Europäisches Patentamt

European Patent Office

Office européen des brevets

(11) Publication number: **0 301 710**
**A1**

## EUROPEAN PATENT APPLICATION

(21) Application number: 88306024.6

(51) Int. Cl.4: **G03D 3/10 , G03F 7/26**

(22) Date of filing: **01.07.88**

(30) Priority: **31.07.87 JP 193362/87**

(43) Date of publication of application:
**01.02.89 Bulletin 89/05**

(84) Designated Contracting States:
**DE FR GB IT**

(71) Applicant: **HITACHI, LTD.**
**6, Kanda Surugadai 4-chome**
**Chiyoda-ku Tokyo 101(JP)**

(72) Inventor: **Wakui, Masateru**
**274 Nakanoshima**
**Mobara-shi Chiba-ken(JP)**

(74) Representative: **Williams, Trevor John et al**
**J.A. KEMP & CO. 14 South Square Gray's Inn**
**London WC1R 5EU(GB)**

(54) **A wet etching apparatus suitable for processing large plates such as glass plates of the liquid-crystal display panels.**

(57) A wet processing apparatus comprising wet processing chambers constituted in such a manner that first wet processing portions in which a first wet processing liquid is used are connected to second wet processing portions in which a second wet processing liquid which is different from the first wet processing liquid is used with shutter devices having a shutter portion which can be opened and closed in order to prevent the wet processing liquids from being mixed with each other.

*FIG. 1*

EP 0 301 710 A1

# A WET ETCHING APPARATUS SUITABLE FOR PROCESSING LARGE PLATES SUCH AS GLASS PLATES OF THE LIQUID-CRYSTAL DISPLAY PANELS

[Industrial Field of the Invention]

This invention relates to wet processing technology, and more particularly to technology suitable for wet processing including developing, etching, and/or stripping resist films.

[Prior Art]

The active matrix type of liquid crystal display panel is known. The liquid crystal display panels of this type are constituted by enclosing liquid crystal in a space (gap) that is formed between upper and lower transparent glass substrates. Displaying with the use of the liquid crystal corresponding to each pixel displaying an image is controlled by transparent pixel electrodes (ITO) which are respectively disposed in each pixel and a common transparent pixel electrode (ITO) which is commonly distributed to all of the pixels. The potential of the transparent pixel electrodes distributed to each pixel is controlled by a thin film transistor which is a so called TFT.

Each of the transparent pixel electrodes and each of the thin film transistors are formed on the surface of the lower transparent glass substrate (facing the liquid crystal). The thin film transistors are so formed that the layers of a gate electrode, gate insulating film, i-semiconductor layer, source electrode and a drain electrode are laid successively upon each other. The scanning signal line (gate line) for selecting the thin film transistor is integrally formed with the gate electrode. The image signal line (drain line) is integrally formed with the drain electrode. The transparent pixel electrode is connected to the source electrode of the above-described thin film transistor. The above-described common transparent pixel electrode is formed on the surface of the upper transparent glass substrate (facing the liquid crystal).

Wet processing technology (wet process) is utilized when the pattern of each of the layers forming the thin film transistor of the liquid crystal display panels, the transparent pixel electrodes and the common transparent pixel electrode are formed. This term "wet processing technology" is used to signify the developing, etching (wet etching) and stripping sequentially carried out in these processes.

The development practised in this connection is an art after a latent image of a pattern has been formed on a photoresist film applied to the uppermost layer of the above-described layers, the photoresist film is developed for the purpose of forming an etching mask. The etching is a process in which wet etching is conducted by utilizing the above-described etching mask formed in the development process for the purpose of forming the above-described layers into a predetermined pattern. The stripping is a process in which the above-described etching mask is stripped and removed.

[Problems to be Solved by the Invention]

Each of these processes, that is the developing, etching and stripping of the above-described wet process, is conducted in a so-called batch processing manner. This batch processing is a method in which a plurality of transparent glass substrates to which a photoresist film has been applied over the above-described layers are accommodated in a substrate cassette where they can be subjected to each process. The transparent glass substrates are accommodated in the substrate cassette in such a manner that they are disposed vertically with the surface to which the photoresist film is applied (surface facing the liquid crystal) standing erect.

The development process comprises the photoresist film being developed by a developer, washed with water several times, dried with a rinser dryer, and post baked (the photoresist film being baked). The development is conducted in such a manner that the above-described substrate cassette is transported by an operator, and is manually dipped into each of the processing liquids. The development is conducted by an operator who manages it in accordance with a time schedule showing each procedure processes and the time needed to carry out the processes. The etching and stripping processes which are conducted after this development are undertaken in a similar manner.

The inventor of the present invention found a fact after an examination that since each of the individual processes in the wet process is undertaken by an operator, each process slightly differs from each other. as

2

a result of which, a stable wet processing cannot be conducted. For example, a etching mask cannot be properly formed in the development process with certainty, many defects being generated due to over-etching or lack of etching. As a result of this, the manufacturing yield of liquid crystal display devices produced in this way is low.

Furthermore, the inventor of the present invention found in his studies of the above-described wet processing that subsequent processes are often held up, and that each process cannot therefore be conducted smoothly. That is, in the above-described wet processing, a very long waiting time is inevitable between the development and etching process and between the etching and the stripping process. A long time is therefore required to complete the manufacturing of liquid crystal display devices since a long time is required to process of the same. At present, it takes close to 30 days for the production of a liquid crystal display to be completed.

In order to solve the above-described problems, the inventor of the present invention has examined a serial automated wet processing line system. This serial automated wet processing line system is so constituted that the above-described batch processing method is employed and substrate cassettes accommodating a plurality of transparent glass substrates are sequentially and automatically dipped into the corresponding processing liquids.

However, since the surface of a transparent glass substrate to be accommodated in the substrate cassette and to be processed is shielded by the other transparent glass substrates, uneven portions to be processed tend to occur in each processes of developing, etching and stripping. Especially since spray washing from two sides cannot be conducted, ionic pollution and/or foreign matter is brought into the next processing chamber, necessitating the provision of many processing chambers in order to remove the polluting matter. Furthermore, in the drying process conducted in the final stage of each of the processes, since the radiant heat cannot be utilized, the surface of the transparent glass substrate to be processed cannot be sufficiently dried. That is, it is difficult to realize an effective serial automated line system.

The inventor of the present invention therefore studied the possibility of employing a so-called sheet processing system in which the transparent glass substrates are processed one by one. This serial automated line system is constituted such that the transparent glass substrates are one by one held by, for example, a collet, in which state they are dipped in the processing liquid. The transparent glass substrates are horizontally conveyed by a belt conveyer in such a manner that the surface to be processed faces upwardly, this surface to be processed being applied with the processing liquid by means of a spray or a shower with the surface to be processed facing upwardly.

However, since the area required to install these processing chambers and to convey the transparent glass substrates is considerable, the overall size of the wet processing apparatus forming the serial automated line system also becomes rather large. The overall length of a serial automated line system as designed by the inventor of the present invention amounts to substantially 70 [m]r. That is, it is difficult to realize a serial automated line system in this form.

Furthermore, according to the studies conducted by the inventor of the present invention, an important matter to be considered when designing a serial automated line system is to make sure that control of the processes of the wet processing during sequential application of each of these processes to the transparent glass substrate is possible and effective. For example, in the etching process, it is important to control the time taken from the moment when the transparent glass substrate is drawn out from the etching processing chamber after the etching of the layer formed on the surface of the transparent glass substrate to be processed to the moment when the etchant adhered at the time of the above-described process is washed off. That is, it is important to define the time for completion of the etching process.

However, since the time required to complete etching differs with the material used to constitute the layer to which the etching is applied, it is very difficult to control this time span. If the time is too long, etching proceeds too far, causing overetching, while if the time is too short, insufficient etching will result. This non- uniformity of the time required for etching causes many defective products to be manufactured. Consequently, the product yield of the liquid crystal displays is poor.

It is an object of the present invention to provide improved wet processing technology by means of which a serial automated line system for wet processing can be materialized.

It is another object of the present invention to provide improved wet processing technology by which a serial automated line system for wet processing including a development process, etching process and stripping process can be constituted.

It is a further object of the present invention to provide improved wet processing technology by means of which stable wet processing can be conducted, and in which the floor area required for the wet processing can be reduced.

It is a still further object of the present invention to provide improved wet processing technology by means of which mass production wet processing can be realized, and in which the size of the wet processing apparatus can be reduced.

It is yet another object of the present invention to provide an improve wet processing technology by which the yield of the production can be improved.

It is yet another object of the present invention to provide improved wet processing technology which allows the time required to complete wet processing to be shortened so that the total time required to complete production can be reduced.

It is yet another object of the present invention to provide improved wet processing technology which allows each of the wet processing steps to be properly controlled, and more particularly to provide improved wet processing technology which allows at least the development process and the etching process to be properly controlled.

It is yet another object of the present invention to provide improved wet processing technology by means of which the floor area of the wet processing chambers can be reduced and the overall size of the wet processing apparatus can thereby be reduced.

It is yet another object of the present invention to provide improved wet processing technology in which dropping of the wet processing liquid which adhered to the surface to be processed when the substrates to be processed pass through the wet processing chamber can be prevented in order to avoid mixing of different wet processing liquids and thus to improve the consistency of the wet processing.

The above and further objects and novel features of the invention will more fully apparent from the following detailed description taken in connection with the accompanying drawings.

### [Means to Solve the Problems]

A representative type of the invention disclosed i this application can be briefly explained as follows:

A wet processing apparatus comprising wet processing chambers constituted in such a manner that first wet processing portions in which a first wet processing liquid is used are connected to second wet processing portions in which a second wet processing liquid is used with shutter devices having a shutter portion which can be opened and closed in order to prevent the wet processing liquids from being mixed with each other. Each of first wet processing portions of the wet processing chambers and said second wet processing portions are respectively disposed vertically with the shutter portion of the shutter device.

Furthermore, the present invention is characterized in that the above-described wet processing chamber is constituted in such a manner that the substrates to be processed can be inserted in a sheet manner with the substrate surface to be processed disposed substantially vertical.

The present invention is characterized in that the substrate supporting jig of the wet processing apparatus for supporting the substrate includes supporting sides for supporting the substrates in a sheet manner with the substrate surface to be processed disposed substantially vertically, and that the supporting sides comprises portion to be supported and portion to be conveyed.

### [Operation]

By making use of the means described above, since the wet processing in the second wet processing portion can be conducted immediately after the wet processing in the first wet processing portion has been completed, control of the wet processing can be properly conducted. For example, in regard to the etching process, since washing the surface of the substrate to be processed can be conducted immediately after etching has been completed, control of the time required to complete etching can be properly conducted. Furthermore, since a shutter portion is provided between the first wet processing portion and the second wet processing portion, the individual wet processing liquids do not mix with each other. Furthermore, since a second wet processing portion can be formed in the area occupied by the first wet processing portion, the area occupied by the wet processing chamber as a whole can be reduced, whereby the size of the entire wet processing apparatus can also be reduced.

Furthermore, uneven processing can be prevented by using the sheet processing, and a standard quality of wet processing can thus be conducted consistently. This allows wet processing to be conducted in a mass production manner. By disposing the substrates vertically, the floor area required to conduct the wet processing can be reduced. Consequently, the size of the wet processing apparatus as a whole can be reduced.

The size of the wet processing apparatus itself can be reduced since the portion to be supported and or

4

the portion to be conveyed can be formed to have the size necessary to form the side which supports the above-described jig which in turn supports the substrate. In this way the size of the jig which supports the substrate can itself be reduced to a similar. As a result of this, the size of the wet processing apparatus can be reduced.

The structure of the present invention will now be described with reference to an embodiment in which the present invention is applied to wet processing technology for use in making an active matrix type of liquid crystal display device.

Throughout the accompanying drawings in which illustrate the embodiment. parts having the same functions are given the same reference numerals, and separate descriptions of the same are omitted.

## BRIEF DESCRIPTION OF THE DRAWINGS

Fig. 1 is a schematic structual view of a wet processing apparatus provided with a serial automated wet processing line system according to an embodiment III of the present invention;

Fig. 2 is a schematic structural view of a wet processing apparatus provided with a serial automated wet processing line system according to an embodiment I of the present invention;

Fig. 3 is a perspective view illustrating an essential portion of the forehand portion of an developing portion of the wet processing apparatus;

Fig. 4 is an enlarged and perspective view of an essential portion of a wet processing apparatus shown in Fig. 3;

Fig. 5 is a front elevational view of a substrate supporting jig for use in the wet processing apparatus;

Fig. 6 is an enlarged and cross-sectional view of an essential portion of the substrate supporting jig;

Fig. 7 is a front elevational view of a lifting device of the wet processing apparatus;

Fig. 8 is a partial cross-sectional perspective view of a wet processing chamber of the wet processing apparatus;

Fig. 9 is a schematic cross-sectional view of the wet processing chamber of the wet processing apparatus;

Fig. 10 is cross-sectional view illustrating an essential portion of an active matrix type of color liquid crystal display to which a wet processing is applied by the wet processing apparatus;

Fig. 11 is a partial perspective view of a wet processing apparatus provided with a serial automated wet processing line system according to an embodiment II of the present invention;

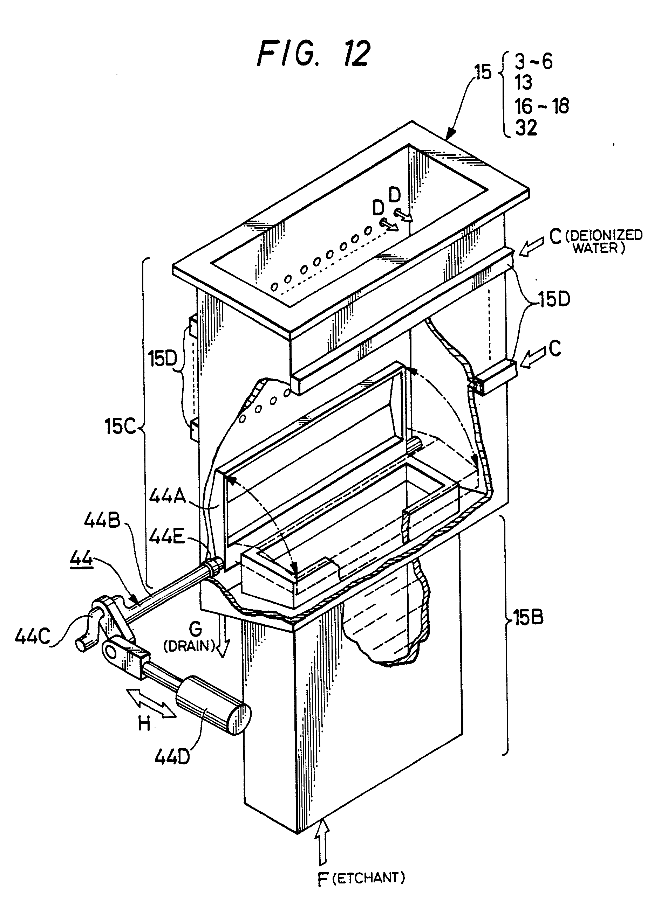

Fig. 12 is a perspective cross-sectional view of an essential portion of a wet processing chamber of a wet processing apparatus provided with a serial automated wet processing line system according to an embodiment III of the present invention;

Fig. 13 is a schematic structural view illustrating a conveying device of the wet processing apparatus;

Fig. 14 is a schematic cross-sectional view of a wet processing chamber of a wet processing apparatus provided with a serial automated wet processing line system according to an embodiment IV of the present invention; and

Fig. 15 is a schematic cross-sectional view of an essential portion of a wet processing apparatus provided with a serial automated wet processing line system according to an embodiment V of the present invention.

## DESCRIPTION OF THE PREFERRED EMBODIMENTS

### (Embodiment I)

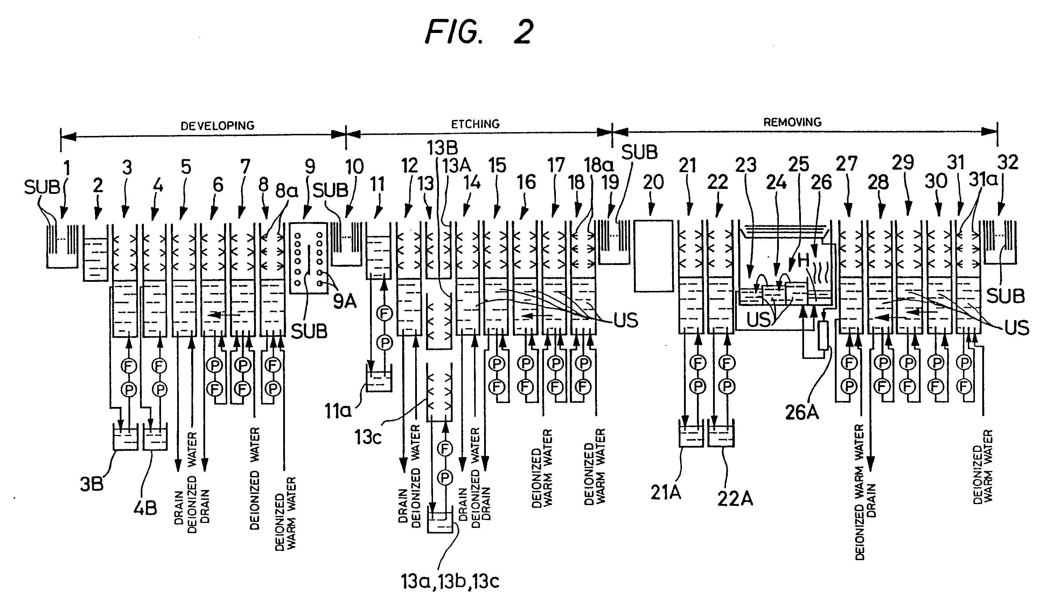

Fig. 2 (schematic structual view) schematically shows a wet processing apparatus provided with a serial automated wet processing line system according to an embodiment I of the present invention.

As shown in Fig. 2, the wet processing apparatus comprises mainly a serial automated line system which is constituted by a developing portion, etching portion (wet etching portion) and a stripping portion.

The developing portion is so constituted that it develops a photoresist film applied to the surface (surface to be processed) of a transparent glass substrate SUB (substrate to be processed) SUB confronting the liquid crystal in order to form an etching mask. The photoresist film applied to the surface of the transparent glass substrate SUB conveyed to the developing portion is in the state that the latent image thereof is formed. The application of the photoresist film is conducted by, for example, a spinner.

The developing portion is constituted in such a manner that the wet processing is successively and automatically conducted in wet processing chambers disposed between a loader (supplying stocker) 1 and an unloader (accommodating stocker) 10 starting from the left one as viewed in this figure. A plurality of wet processing chambers are disposed in the direction in which the transparent glass substrate SUB is conveyed. The conveyance of the transparent glass substrate SUB is conducted in a sheet method.

The transparent glass substrate SUB supplied by the loader 1 is first conveyed to a pre-chamber 2 in which the surface of the transparent glass substrate SUB is washed.

Next, it is conveyed to a first developing chamber 3 or a second developing chamber 4 in which the photoresist film applied to the surface of the transparent glass substrate SUB is developed (dissolved) so that an etching mask is formed. The first developing chamber 3 is filled with, for example, an organic alkali (2.4 [%] tetra methyl ammonium hydroxide) to serve as a developer (wet processing liquid). The second developing chamber 4 is filled with, for example, an inorganic alkali (6[%] potassium hydroxide) to serve as a developer.

Then, it is successively conveyed to a first water washing chamber 5, a second water washing chamber 6, and a third water washing chamber 7, wherein the developer adhered to the surface of the transparent glass substrate SUB is washed.

Then, it is conveyed to a warm water and drying chamber 8 in which it is heated and washed with deionized warm water of substantially 80° C, and the surface of the transparent glass substrate SUB is dried with a hot air 8a blown in the form of an air knife. As this hot air 8a, a hot air of nitrogen gas is used in order to prevent water marks from being formed on the surface of the transparent glass substrate SUB.

Then it is conveyed to a baking furnace 9 in which post baking is conducted. This post baking is conducted, for example, at substantially 120[° C] for 4 [minutes]. The post baking is conducted for the purpose of increasing the resistance of the film against the ensuing etching process by baking the etching mask (photoresist film).

Then it is accommodated in the unloader 10.

The etching portion (wet etching portion) is constituted in such a manner that the etching mask formed by the above-described photoresist film is used, and the above-described layer formed on the surface of the transparent glass substrate SUB is formed into a predetermined pattern. This etching portion is constituted in such a manner that the wet processing is successively and automatically conducted in wet processing chambers disposed between the loader 10 and a unloader 19 starting from the left end chamber viewed as in the figure. Similarly to the developing portion, a plurality of wet processing chambers are disposed in the direction in which the transparent glass substrate SUB is conveyed. The conveyance of the transparent glass substrate SUB is also conducted in a sheet method.

The transparent glass substrate SUB supplied from the above-described loader 10 is, first, conveyed to a pre-chamber 11 in which the surface of the transparent glass substrate SUB is washed. The above-described loader 10 is so constituted that the transparent glass substrate SUB which has been wet processed (development) in the developing portion is supplied. This pre-chamber 11 serves to activate the surface of the materials (in this embodiment, the materials forming the pattern comprises a chrome layer, an aluminum layer and a transparent electrode layer) for forming the pattern and to uniformly start the etching in the etching chamber. The pre-chamber 11 is filled with, for example, dilute hydrochloric acid to serve as a wet processing liquid.

Then, it is conveyed to a water washing chamber 12 in which the surface of the transparent glass substrate SUB is washed.

Next, it is conveyed to an etching chamber 13 in which the above-described layer formed on the surface of the transparent glass substrate SUB is formed into a predetermined patter with the use of the etching mask formed by the above-described photoresist film. A plurality of the etching chambers 13 are provided in accordance with the types of the materials forming the pattern layers. In this embodiment. since the wet processing apparatus uses, as described above, three types of materials. it is constituted by an etching chamber 13A for chrome, an etching chamber 13B for aluminum, and an etching chamber 13C for a transparent electrode. The etching chamber 13A is filled with, for example. ammon ceric nitrate to serve as the etchant (wet processing liquid). The etching chamber 13B is filled with. for example, $H_3PO_4$ + $HNO_3$ + $CH_3COOH$ to serve as the etchant. The etching chamber 13C is filled with, for example, $HNO_3$ + $HCl$ to serve as the etchant.

Then it is conveyed to a water washing chamber 14 in which the etchant adhered to the surface of the transparent glass substrate SUB is washed. The water washing chamber 14 is provided with three types of water washing chambers corresponding to the ecthing chambers 13A, 13B and 13C (omitted from the illustration).

Next, it is successively conveyed to a first deionized warm water chamber 15, a second deionized warm water chamber 16, and a third deionized warm water chamber 17, in which the surface of the transparent glass substrate SUB is washed.

Then, it is conveyed to a warm water and drying chamber 18 in which it is washed with deionized warm water, and the surface of the transparent glass substrate SUB is dried with the blow of hot air 18a. The hot air 18a utilizes, similarly to the above-described hot air 8a, a nitrogen gas in order to prevent the water marks from being formed on the surface of the transparent glass substrate SUB.

Next, it is accommodated in a unloader 19.

The stripping portion is so constituted that the above-described etching mask is stripped and removed from the surface of the transparent glass substrate SUB. This stripping portion is constituted in such a manner that the wet processing is successively and automatically conducted in wet processing chambers disposed between the loader 19 to a unloader 32 starting from the left end chamber as viewed in the figure. A plurality of wet processing chambers are disposed in the direction in which the transparent glass substrate SUB is conveyed in a manner similar to that for the etching portion. The conveyance of the transparent glass substrate SUB is similarly conducted in the sheet method.

The transparent glass substrate SUB supplied from the loader 19 is first conveyed to a baking furnace 20 in which baking is conducted. The baking is conducted at, for example, substantially 120 [°C] for 4 [minutes].

Then, it is successively conveyed to a first stripping chamber 21 and a second stripping chamber 22, in which the above-described etching mask formed on the surface of the transparent glass substrate SUB is stripped (dissolved). The first stripping chamber 21 and the second stripping chamber 22 are filled with, for example, a mixed solvent (ortho dichloro benzene and the like) to serve as the stripper (wet processing liquid).

Next, it is successively conveyed to a first stripper removing chamber 23, a second stripper removing chamber 24, a third stripper removing chamber 25, and a fourth stripper removing chamber 26, in which the stripper adhered to the surface of the transparent glass substrate SUB is dissolved. The stripper removing chambers 23, 24, 25 and 26 respectively filled with methylene chloride to serve as the stripper removing liquid (wet processing liquid). The stripper removing liquid in the fourth stripper removing chamber 26 is made flow into the third stripper removing chamber 25 via a water separator 26A after the stripper removing liquid in the fourth stripper removing chamber 26 has been heated so as to be evaporated by a heater H, and has been condensed. A stripper removing liquid is made flow into the second stripper removing chamber 24 from the third stripper removing chamber 25, and the same is made flow into the first stripper removing chamber 23 from the second stripper removing chamber 24. The stripper removing liquid in the first stripper removing chamber 23 is made flow into the fourth stripper removing chamber 26. Consequently, it is circulated. The stripper adhered to the surface of the transparent glass substrate SUB is successively dissolved in, starting from, the first stripper removing chamber 23, and finally is vapor-washed with steam of the stripper removing liquid from the fourth stripper removing chamber 26. In this vapor washing, as the surface of the transparent glass substrate SUB is relatively cooled down, the efficiency in washing can be improved since the steam can be easily adhered.

Then it is conveyed to a deionized warm water chamber 27 in which the surface of the transparent glass substrate SUB is washed with deionized warm water, and is then conveyed to a first deionized warm water chamber 28, a second deionized warm water chamber 29, and a third deionized warm water chamber 30, in which the surface of the transparent glass substrate SUBs is washed.

Next, it is conveyed to a warm water and drying chamber 31 in which it is washed with deionized warm water, and is applied with a blow of hot air 31a so that the surface of the transparent glass substrate SUB is dried. The hot air 31a employs, similarly to the above-described hot air 8a and 18a, hot air of nitrogen gas.

Then, it is conveyed to a unloader 32.

After sequentially conducting the developing, etching and stripping, the wet processing is completed.

Next, the specific structure of the components forming the serial automated wet processing line system will now be described.

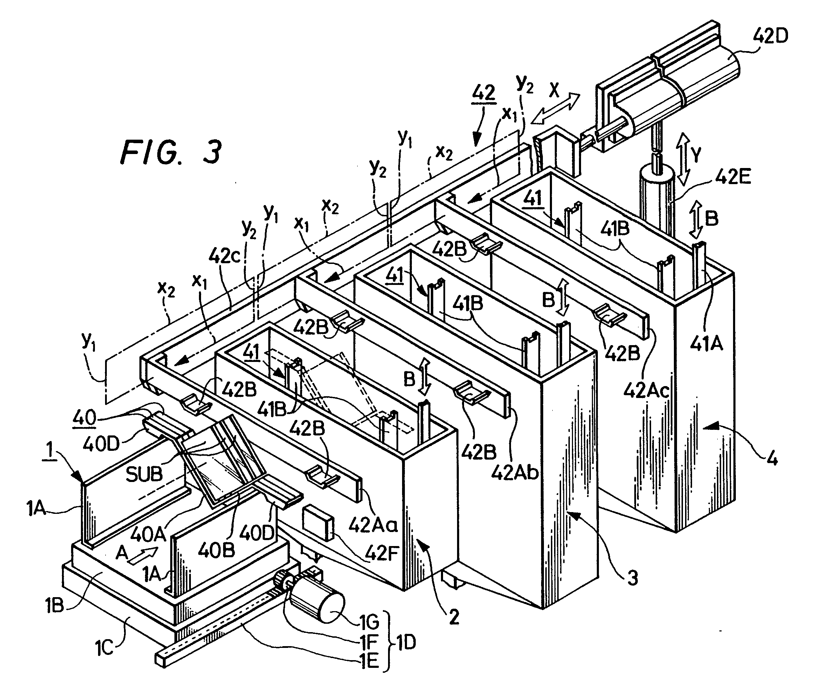

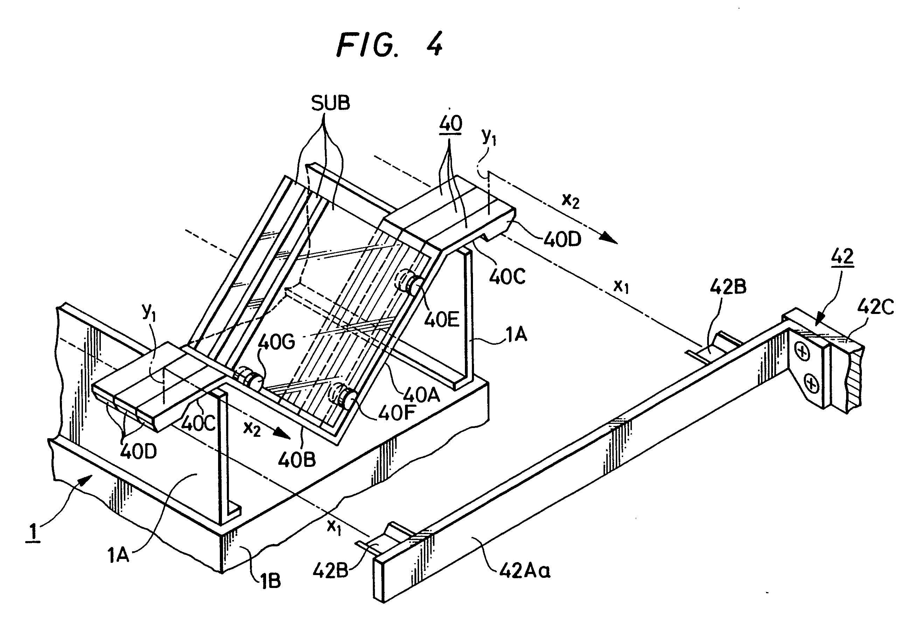

The loaders and the unloaders 1, 10, 19, and 32 which are each provided for the processes are constituted as shown in Figs. 3 and 4. Fig. 3 is a perspective view of an essential portion of the forehand portion of the developing portion of the wet processing apparatus. Fig. 4 is an enlarged perspective view of the loader 1. Since the loaders and the unloaders 1, 10, 19, and 32 are formed, in principle, in the same structure, only the loader 1 will be described with reference to the drawing.

As shown in Figs. 3 and 4, the loader (supplying stocker) 1 is so constituted in such a manner that it can detachably supports a substrate supporting jig (substrate supporting means) 40 which supports the transparent glass substrate SUB in a sheet manner. The loader 1 mainly comprises a pair of jig supporting portions 1A, a jig supporting frame 1B, a movable table 1C and a driving device 1D.

The jig supporting portion 1A is secured to the jig supporting frame 1B, and is so constituted that it can detachably supports a plurality of substrate supporting jigs 40 in the direction of the conveyance of the transparent glass substrate SUB. The jig supporting portion 1A is made of a light aluminum alloy of a relatively light weight and having an excellent mechanical strength. The jig supporting portion 1A may be formed by a metal such as titan or a resin material such as a peak (polyethyi ether keton).

The jig supporting frame IB is so constituted that it can be detachably mounted on the movable table 1C.

The movable table 1C is so constituted that jig supporting frame 1B can be moved in the direction (direction designated by an arrow A) of the conveyance of the transparent glass substrate SUB by the driving device 1D. This conveyance is so constituted that after one substrate supporting jig 40 has been conveyed, the next substrate supporting jig 40 is located to the position at which the former one has been located.

The driving device 1D mainly comprises a rack 1E secured to the movable table 1C, a pinion 1F which is to be brought into engagement with the rack 1F, and a step motor 1G which rotates the pinion 1F in a stepped manner.

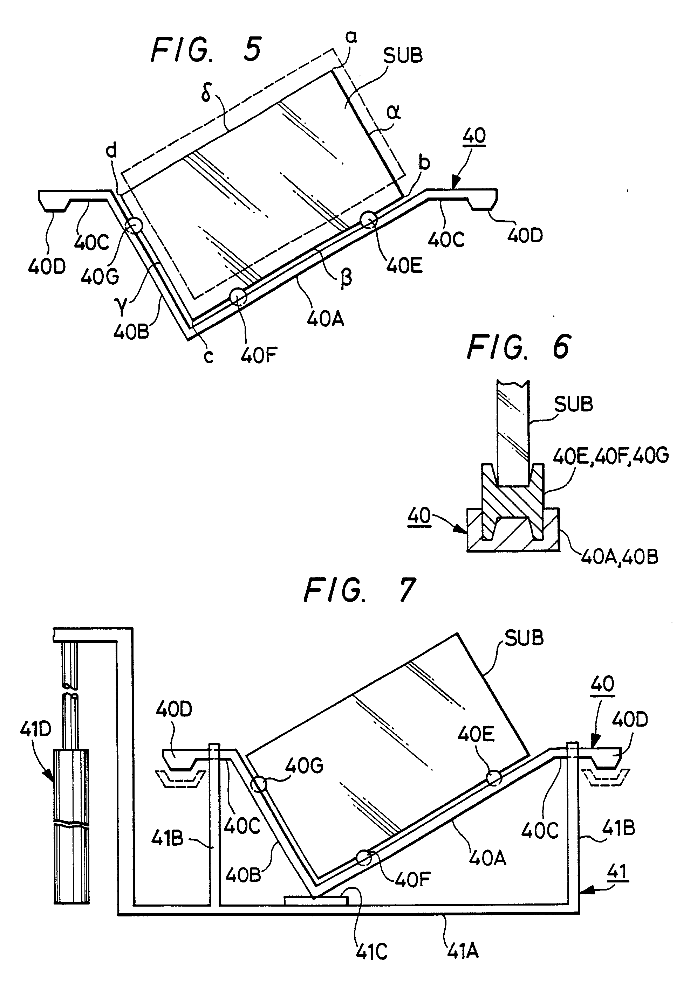

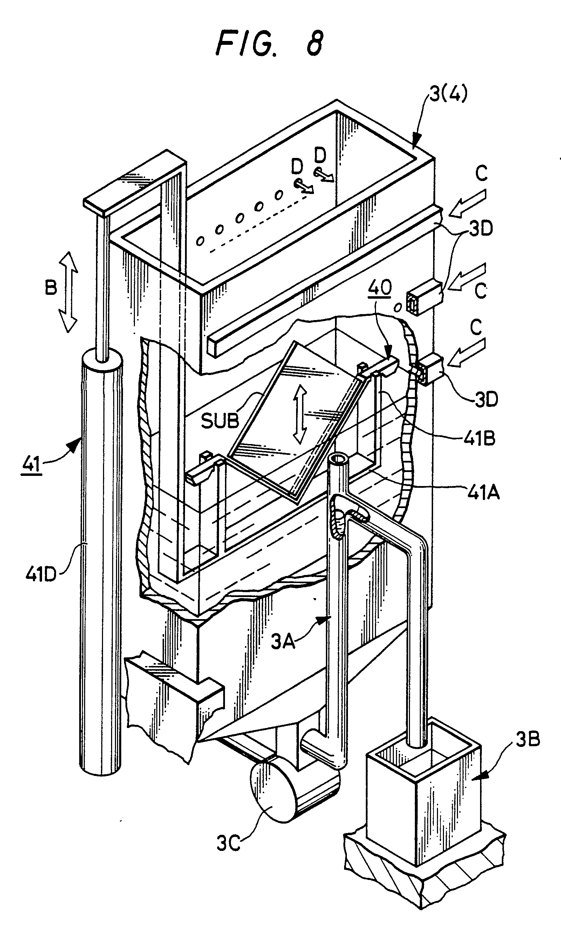

The substrate supporting jig 40 for supporting the above-described transparent glass substrate SUB in a sheet manner is formed as shown in Figs. 3, 4, 5 and 6. Fig. 5 is a front elevational view of the substrate supporting jig 40, and Fig. 6 is an enlarged cross-sectional view of the substrate supporting jig 40.

As shown in Figs. 3 to 6, the substrate supporting jig (substrate supporting means) 40 is so constituted that the above-described transparent glass substrate SUB is supported in a sheet manner. That is, the substrate supporting jig 40 is so constituted that it supports a transparent glass substrate SUB in order to prevent this transparent glass substrate SUB from being covered by the other transparent glass substrate SUB at the time of wet processing. This substrate supporting jig 40 is so constituted that it supports the transparent glass substrate SUB in such a manner that the surface (surface to be processed) thereof is actually disposed vertical.

The substrate supporting jig 40 mainly comprises two supporting sides 40A and 40B, a portion 40C to be supported, a portion 40D to be conveyed, and supporting members 40E to 40G. The two supporting sides 40A and 40B are so formed that they intersect at substantially 90° each other. That is, the two supporting sides 40A and 40B are so constituted that they form a L-shape or a V-shape. For example, the substrate supporting jig 40 for supporting a rectangle transparent glass substrate SUB of substantially 10 x 10 [inch](specifically it is, for example, 270 x 200 [mm]) is designed in such a manner that the longer supporting side 40A is, for example, made substantially 350 [mm], while the shorter supporting side 40B is, for example, made substantially 300 [mm]. Each of the supporting sides 40A and 40B is made of a metal with a high fusing point (in this embodiment, it is titan) in order to withstand each wet processing liquids and heat of the baking furnaces 9 and 20. Each of the supporting sides 40A and 40B may be made of a resin material such as a peak material.

The supporting side 40A is provided with two supporting members 40E and 40F, while the supporting side 40B is provided with a supporting member 40G. That is, the substrate supporting jig 40 is provided with three supporting members 40E to 40G. The supporting members 40E to 40G are constituted in the form of a cylinder, the cylinder being provided with recesses having, as shown in Fig. 6, the cross-sectional shape of an inverted trapezoid. The supporting members 40E to 40G in the form of a cylinder are so constituted that they can smoothly mount the transparent glass substrate SUB on the substrate supporting jig 40 from the position designated by a dashed line shown in Fig. 5. Each recess of the above-described supporting members 40E to 40G is so constituted that the end portion (the sides designated by $\beta$ and $\gamma$ shown in Fig. 5) of the transparent glass substrate SUB can be fitted into the recess due to its dead weight. The transparent glass substrate SUB is supported in such a manner that the two sides (sides $\beta$ and $\gamma$) thereof are supported at three points due to the provision of the above-described three supporting members 40E to 40G. The transparent glass substrate SUB which is thus supported in the three-point supported manner is held by each recess of the supporting members 40E to 40G due to its dead weight without occurrence of shakiness, furthermore, it can be constituted in such a manner that it can be detachably mounted. That is, the transparent glass substrate SUB can be detachably and stably held by the substrate supporting jig 40. The supporting members 40E to 40G are, for example, made of a fluororesin. The supporting members 40E to 40G may be formed by a resin material such as a peak material. If the above-described supporting sides 40A and 40B are made of the similar resin material, they can be integrally formed.

The above-described transparent glass substrate SUB is so constituted that it can be mounted on the substrate supporting jig 40 by a conveying device (omitted from the illustration) which holds and conveys it by vacuum absorbing the reverse side thereof which is the opposite of the surface thereof.

The portion 40C to be supported is integrally formed with the supporting sides 40A and 40B, respectively. This portion 40C to be supported is so constituted that it is brought into contact with the jig supporting portion 1A of the above-described loader 1 so that it supports the substrate supporting jig 40 at the loader 1. The portion 40C to be supported is also constituted in such a manner that it can support the substrate supporting jig 40 at the time of wet processing.

The portion 40D to be conveyed is constituted in the form of a projection, and is constituted in such a manner that the substrate supporting jig 40 can be stably conveyed from the loader 1 to each wet processing chamber. The portion 40D to be conveyed is, as described later, so constituted that a finger portion 42A for conveying of a conveying device 42 can brought into contact with it.

The substrate supporting jig 40 is integrally formed with the supporting side 40A, the supporting side 40B, the portion 40C to be supported, the portion 40D to be supported, and/or the supporting members 40E to 40G. That is, the substrate supporting jig 40 is simply formed and as well is easily formed.

As described above, in the wet processing apparatus, since the transparent glass substrate SUB (substrate to be processed) is held in a sheet method and the above-described substrate supporting jig (substrate supporting means) 40 is constituted which supports the transparent glass substrate SUB (substrate to be processed) in such a manner that the surface (surface to be processed) of the transparent glass substrate SUB is actually made vertical, the surface of the transparent glass substrate SUB necessarily is exposed at the time of wet processing so that uneven degree of wet processing can be prevented, as a result of this, the wet processing can be stably conducted. As a result of this, the wet processing can be conducted in a mass production manner. Furthermore, since the transparent glass substrate SUB can be disposed vertically so as to reduce the area which is necessary to conduct the wet processing, the overall size of the apparatus can be reduced.

Furthermore, since the above-described substrate supporting jig 40 supports the transparent glass substrate SUB in such a manner that it is made vertically (the surface is made substantially vertical), the removal of the wet processing liquid can be instantaneously conducted. That is, since the surface of the transparent glass substrate SUB can be dried well (drying speed can be increased), the ensuing wet processing can be immediately conducted so that time required to complete the products can be shortened. Furthermore, since the surface of the transparent glass substrate SUB can be dried well in each wet processing, the ensuing wet processing can be immediately conducted so that the preceding wet processing liquid can be prevented from being mixed with the ensuing wet processing liquid. Furthermore, in each wet processing, since the surface of the transparent glass substrate SUB can be dried well, the use of a flammable solvent such as isopropyl alcohol (IPA) for causing the drying speed to be increased can be stopped, as a result of this, safety in the wet processing can be improved.

The above-described substrate supporting jig 40 is so constituted that the supporting sides 40A and 40B thereof form a predetermined angle with respect to the horizontal plane, and is so constituted that the transparent glass substrate SUB is supported obliquely. The transparent glass substrate SUB supported obliquely is arranged to be disposed in such a manner that one of the outer corners (corner c shown in Fig. 5) thereof is positioned lowermost with respect to the other corners (corners a, b and d). That is, the substrate supporting jig 40 is so constituted that it can support the transparent glass substrate SUB so as to make the wet processing liquid adhered to the surface (surface to be processed) actually drop from one point (corner c).

As described above, since the substrate supporting jig 40 can make liquid drop from one point (corner c) of the transparent glass substrate SUB by supporting the transparent glass substrate SUB obliquely, the removal of the overflowed wet processing liquid can be instantaneously conducted.

Furthermore, the above-described substrate supporting jig 40 is so constituted that, as shown in Fig. 5, it supports the transparent glass substrate SUB in such a manner that any surface of the transparent glass substrate SUB is not present in the direction to which the gravitation is applied. That is, the substrate supporting jig 40 supports the transparent glass substrate SUB in such a manner that the side $\beta$ in which any surface of the above-described transparent glass substrate SUB is not present in the direction of the gravitation is supported by the supporting side 40A with the supporting members 40E and 40F, while the side $\gamma$ is supported by the supporting side 40B with the supporting member 40G.

As described above, since the substrate supporting jig 40 supports the transparent glass substrate SUB in such a manner that any surface thereof is not present in the direction of the gravitation, drop of the wet processing liquid onto the surface of the transparent glass substrate SUB from each of the supporting members 40E, 40F, and 40G can be prevented. Therefore, the uneven wet processing conducted on the surface of the transparent glass substrate SUB can be reduced. If the transparent glass substrate SUB is supported in such a manner that the surface thereof is present in the direction of the gravitation (at the sides $\alpha$ and $\delta$), wet processing liquid will drop onto the surface of the transparent glass substrate SUB from the supporting members.

As described above, the substrate supporting jig 40 is constituted in such a manner that it can support the transparent glass substrate SUB by the two supporting sides 40A AND 40B thereof which are intersected at a predetermined angle.

Since the substrate supporting jig 40 supports the transparent glass substrate SUB by its two supporting sides 40A and 40B, the size of the transparent glass substrate SUB can be freely varied. That is, the substrate supporting jig 40 can freely and stably support not only the transparent glass substrate SUB of 10 inches but also larger or smaller transparent glass substrate. The capability of supporting the transparent glass substrates regardless of the size of the same can cause the wet processing to be varied. That is, this wet processing can be applied not only to the liquid crystal display device, but also to a transparent glass substrate on which reticles or a photomask is formed, a semiconductor wafer (semiconductor substrate) for forming semiconductor devices. Since the substrate supporting jig 40 supports the transparent glass substrate SUB by a three points support manner with the use of the three supporting members 40E to 40G, the transparent glass substrate SUB can be freely supported regardless of the size of the same.

Furthermore, since the substrate supporting jig 40 is formed in such a manner that the supporting sides 40A and 40B for supporting the transparent glass substrate SUB are arranged to form a L-shape or a V-shape with the two sides 40A and 40B intersected, the wet processing liquid adhered to the substrate supporting jig 40 can be positively dropped from a point of the intersection. As a result of this, liquid drop can be instantaneously conducted.

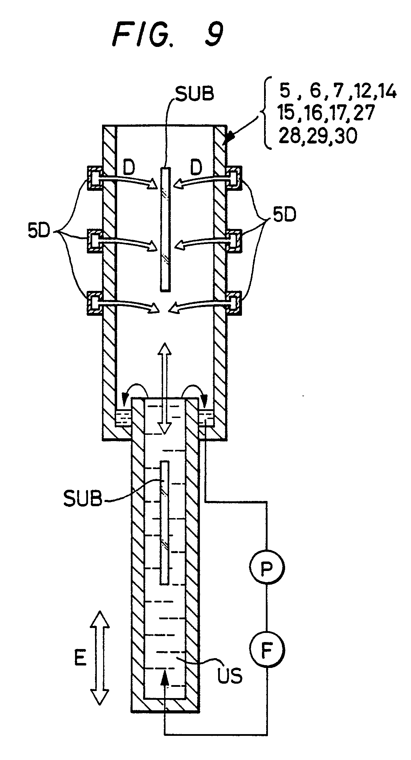

The substrate supporting jig 40 is, as shown in Fig. 7, (front elevational view of a lifting device), conveyed from the loader 1 to a lifting device 41 provided for each wet processing chamber. The substrate supporting jig 40 which has been conveyed by the lifting device 41 is dipped into the wet processing liquid in the wet processing chamber.

The Lifting device 41 mainly comprises, as shown in Fig. 7, a vertically movable frame 41A, a jig supporting portion 41B, rotation stopper 41C and a vertical movement driving device 41D.

The vertical movable frame 41A is shaped in the form of an L-shape, and a part thereof is integrally formed with the jig supporting portion 41B (or provided individually). The vertical movable frame 41A is constituted in such a manner that the substrate supporting jig 40 can be supported with the aid of the jig supporting portion 41B. The jig supporting portion 41B is formed in such a manner that it can be brought into contact with the portion 40C to be supported of the substrate supporting jig 40. The jig supporting portion 41B, at the portion of the contact thereof, is formed in a recessed shape in order to stably support the portion 40C to be supported of the substrate supporting jig 40.

The vertically movable frame 41A is, at the position thereof at which the supporting sides 40A and 40B of the substrate supporting jig 40 are intersected, provided with a rotation stopper 41C. The rotation stopper 41C is formed in a recessed shape in order to restrict the positions of the supporting sides 40A and 40B of the substrate supporting jig 40 from the two sides of the latter. This rotation stopper 41C is formed in such a manner that it can stably support the substrate supporting jig 40 without occurrence of the rotation of the same.

The vertically movable frame 41A, jig supporting portion 41B, and the rotation stopper 41C are respectively formed by, for example, a titan steel, or other metallic material having a high fusible point, peak material, or fluororesin or the like in order to withstand, at least, the wet processing liquid.

The other portion of the vertically movable frame 41A is connected to the vertical movement driving device 41D. The vertical movement driving device 41D is constituted in such a manner that it can vertically (in the direction designated by an arrow B) move the vertically movable frame 41A. That is, the vertical movement driving device 41D supports, at the position adjacent to the insertion port of the wet processing chamber, the substrate supporting jig 40 which has been conveyed, and inserts (lowers) this substrate supporting jig 40 into the wet processing chamber in which the wet processing can be applied to the surface of the transparent glass substrate SUB. The vertical movement driving device 41D is constituted in such a manner that it can again move (raises) the glass substrate SUB which has been subjected to wet processing to the position adjacent to the insertion port so that the substrate supporting jig 40 is able to be conveyed to the successive wet processing chamber. This vertical movement driving device 41D is formed by, for example, an air cylinder. The vertical movement driving device 41D may be formed by a lifting mechanism comprising a hydraulic cylinder and a step motor. The operation of the above-described vertical movement driving device 41D, that is the movement of the vertically movable frame 41A, is controlled in a sequence manner by a microcomputer (omitted from the illustration).

The developing chamber 3 (or 4) in the developing portion to serve as one of the above-described wet processing chambers is constituted, as shown in Figs. 3 and 8 (partial cross-sectional view of a developing chamber) in such a manner that the surface of the transparent glass substrate SUB can be subjected to wet processing together with the substrate supporting jig 40 and the vertically movable frame 41A of the lifting device 41. That is, the developing chamber 3 is basically formed by a hollow parallelpiped having an insertion portion into which the transparent glass substrate SUB is inserted at the upper portion thereof. The developing chamber 3 is constituted in such a manner that it accommodates the transparent glass substrate SUB in a sheet method and the surface of the same is substantially stood erect.

A liquid chamber portion is formed at the bottom of the developing chamber 3 for enclosing developer (wet processing liquid). The developer in the liquid chamber portion is arranged to be discharged into a sub-chamber 3B if it exceeds a reference level by means of a liquid level maintaining mechanism 3A by the amount exceeding the level. As a result of this, the reference level can be always maintained. The liquid level maintaining mechanism 3A is secured to the side wall of the developing chamber 3 by means of, for example, welding. The lowermost portion of the developing chamber 3 is formed in a V-shape in order to accumulate sediment so that the sedimentation of impurities is prevented. A discharge valve 3C is provided at the lowermost portion of the developing chamber 3 in order to discharge the developer.

Although the illustration is omitted from Fig. 8, the developer discharged to the sub-tank 3B is supplied (circulated) to the developing chamber 3 via a pump P and a filter F. As described above, the sub-tank 3B is provided for the developing chamber 3 in order to circulate the developer. As a result of this, the actual quantity of the developer can be increased, causing thereby the size of the developing chamber 3 to be decreased. Although the size of the developing chamber 3 is small, the capacity of the same is relatively large. Therefore, development can be stably conducted. A sub-chamber 4B is provided for the developing chamber 4 in the developing portion. The sub-chamber 11 in the etching portion is provided with a sub-tank 11a, the etching chambers 13A to 13C are respectively provided with corresponding sub-tanks 13a to 13c. The stripping chambers 21 and 22 in the stripping portion are respectively provided with corresponding sub-tanks 21A and 22B.

A processing liquid spraying device 3D is formed between the insertion portion of the developing chamber 3 into which the transparent glass substrate SUB is inserted and the liquid chamber portion. The processing liquid spraying device 3D is formed in such a manner that it sprays the developer to the surface of the transparent glass substrate SUB which has been subjected to the development in the liquid chamber portion in the developing chamber 3.

The developer to be sprayed is a new one. The processing liquid spraying device 3D, although the source being omitted from the illustration, comprises a liquid supplying chamber for supplying new developer, a control valve for controlling the amount of the developer, and a supplying piping through which the developer is supplied (in the direction designated by an arrow C). The supplying piping of the processing liquid spraying device 3D is arranged around the developing chamber 3, and is so constituted that the developer is jetted from the jetting portion formed in the side wall of the developing chamber 3 (in the direction designated by an arrow C). That is, since the developing chamber 3 is so constituted that the supplying piping of the processing liquid spraying device 3D is provided around the outer surface thereof, the inner surface thereof is made flat so that the washing of the inner surface can be easily conducted at the time of maintenance.

Since the liquid chamber portion of the developing chamber 3 is always supplied with constant amount of new developer by means of the processing liquid spraying device 3D, and since the constant amount of the developer is always discharged by the liquid level maintaining mechanism 3A, the density of the developer can be maintained constant. That is, in the development process in the developing chamber 3, the constant density of the developer can be always made constant and the developing condition can be always maintained, so that stable developing can be conducted.

The developing chamber 3 is formed, for example, by a resin material such as peak material in order to withstand the developer. The successive water washing chambers 5, 6 and 7 of the developing chamber 3 and the etching chamber 13 of the etching portion are also formed by the resin material. The warm water and drying chambers 8, 18 and 32, and the ionized warm water chambers 15, 16, 17 and 27 of the wet processing chambers are made of a metallic material such as stainless steel.

As described above, the wet processing apparatus is constituted in such a manner that the developing chamber (wet processing chamber) 3 is formed in such a manner thatthe transparent glass substrate SUB can be inserted in a sheet method and the surface of the transparent glass substrate SUB can be actually stood erect. Furthermore, the liquid chamber portion for gathering the developer is formed at the bottom of the developing chamber 3 and the processing liquid spraying device 3D for spraying the developer is formed between the portion into which the transparent glass substrate SUB is inserted and the above-described liquid chamber portion in the above-described developing chamber 3. As a result of this, since uneven developed result can be prevented with the aid of the processing liquid spraying device 3D after the developing is conducted in the liquid chamber portion. the wet processing can be conducted stably.

As described above. in the wet processing apparatus. since a new liquid is used as the developer sprayed from the processing liquid spraying device 3D. new liquid can be always sprayed to the surface of the transparent glass substrate SUB. As a result of this. the wet processing can be conducted stably. Furthermore, since the new developer sprayed with the processing liquid spraying device 3D is per se supplied to the liquid chamber portion. the density of the developer can be maintained constant. Consequently, the development can be conducted stably.

The wet processing chambers, that is, the water washing chambers 5, 6, 7, 12, and 14 and deionized warm water chambers 15, 16, 17, 28, 28, 29, and 30 (represented by the water washing chamber 5 hereinafter) are respectively formed as shown in Fig.9 (schematic cross-sectional view of the wet processing chamber). The water washing chamber 5 is basically formed in a similar manner to that of the developing chamber 3, but the washing liquid is jetted from the bottom of the liquid chamber and is overflowed over the entire surface of the liquid in the liquid chamber portion. This water washing chamber 5 is constituted in such a manner that the impurities with small specific gravitation such as resin type is made discharge by means of overflowing. A processing liquid spraying device 5D, similar to that in the developing chamber 3, is provided between the insertion port into which the transparent glass substrate SUB is inserted and the liquid chamber portion.

The warm water and drying chambers 8, 18, and 31 of the wet processing chambers (represented by the warm water and drying chamber 8 hereinafter) are respectively formed basically similar to the water washing chamber 5, but each of which is provided with a hot air blowing device 8A as an alternative to the processing liquid spraying device 5. The hot air blowing device 8A is so constituted that hot air 8a (18a and 31a) is made blow to the surface of the transparent glass substrate SUB in the form of an air knife in order to quickly dry it.

The water washing chambers 14 and the deionized warm water chambers 15 to 17 in the above-described etching portion and the stripper removing chambers 23 to 25 and the deionized warm water washing chambers 28 to 30 in the stripping portion are respectively connected to a ultrasonic oscillators (the specific structure is omitted from the illustration) as designated by a symbol US in Fig. 2. The ultrasonic oscillators are connected in such a manner that the wet processing liquid (washing liquid) in the liquid chamber in the washing chambers can be oscillated in the direction designated by an arrow E shown in Fig. 9.

As described above, since the processing liquid spraying device 5D is provided for the wet processing chamber which is used to serve as a washing chamber and the ultrasonic oscillator is connected to the wet processing chambers, the wet processing liquid (washing liquid) under a pressure can be sprayed by the processing liquid spraying device 5D to the surface of the transparent glass substrate SUB, foreign matters can be removed with a certaintity. Furthermore. since ultrasonic oscillation can be applied to the washing liquid in the liquid chamber portion by means of the ultrasonic oscillator, small impurities adhered to the surface of the transparent glass substrate SUB can be assuredly removed. That is, effect of washing can be improved.

The sub-chamber in the developing portion and the sub-chamber 11 in the etching portion of the wet processing chamber are, respectively formed in the similar manner to that of the developing chamber 3, but the liquid chamber portion is excluded. Therefore, it comprises a processing liquid spraying device only.

Post baking with the baking furnace 9 shown in Fig. 9 in the developing portion is conducted, similar to that conducted in each wet processing chamber, in such a manner that the surface of the transparent glass substrate SUB is actually stood erect. That is, in the baking furnace 9. post baking process is conducted by inserting the transparent glass substrate SUB, and heating the two sides of the transparent glass substrate SUB with a heater 9A.

The baking furnace 20 for conducting baking process in the stripping portion is also formed similar to that of the above-described baking furnace 9.

As described above, since the baking furnace 9 (or 20) is constituted in such a manner that baking can be conducted with the surface of the transparent glass substrate SUB made stood erect, the area occupied by the baking furnace 9 (or 20) can be decreased. causing the size of the wet processing apparatus to be able to be reduced.

Furthermore, the parts of the heater 9A of the above-described baking furnace 9 (or 20) are disposed facing to both sides of the transparent glass substrate SUB. the both sides of the transparent glass substrate SUB can be uniformly heated. As a result of this, the distribution of stress due to heating can be made uniform, and thereby the warp of the transparent glass substrate SUB can be prevented. As a result of this, the damage of the transparent glass substrate SUB and that of each layer due to the stress can be reduced. Consequently, the manufacturing yield in the wet processing can be improved.

The conveying of the transparent glass substrate SUB (that is, the substrate supporting jig 40) from the above-described loader 1 to the wet processing chamber and that from the wet processing chamber to the successive wet processing chamber is conducted by a conveying device 42 shown in Figs. 3 and 4. The conveying device 42 mainly comprises unit-movement member 42Aa, 42Ab, 42Ac,...., conveying finger portion 42B, connection member 42C, X-direction driving device 42D, and Y-direction driving device 42E.

The unit-movement members 42A are respectively disposed between the loader 1 in the developing portion and the sub- chamber 2, the sub-chamber 2 and the developing chamber 3, and the wet processing chamber and the successive wet processing chamber. Each unit-movement member 42A is engaged with the portion 40D to be conveyed of the substrate supporting jig 40, and is respectively provided with a conveying finger portion 42B. The conveying finger portion 42B is formed in a recessed shape in order to be engaged with the portion 40D to be conveyed of the substrate supporting jig 40. The unit-movement member 42 is integrally formed with the conveying finger portion 42B (or individually formed). The unit-movement member 42A and the conveying finger 42B are each formed by a metallic material such as stainless steel which is able to withstand various processing liquids and as well having an excellent mechanical strength.

The unit-movement members 42A disposed between the wet processing chambers are connected by the connection members 42C. The connection members 42C are respectively provided for the processing portions, that is, the developing portion, etching portion and stripping portion. If necessary, a plurality of the connection members 42C may be provided for the developing portion. These connection members 42 are formed in such a manner that the unit-movement members 42A which have been connected can be collectively conveyed.

Each connection member 42 is connected with an X-direction driving device 42D for conveying the transparent glass substrate SUB in the direction of conveyance (direction designated by an arrow X). The X-direction driving device 42D is constituted in such a manner that it can move each unit-movement member 42A in the direction of the conveyance ($X_2$) or the direction opposite to the conveyance ($X_1$).

The X-direction driving device 42D is connected with the Y-direction driving device 42E for vertically conveying the transparent glass substrate SUB (that is, the substrate supporting jig 40). This Y-direction driving device 42E is constituted in such a manner that it can move each unit-movement member 42A connected by the connection member 42 in the upward direction ($y_1$) and downward direction ($y_2$).

The X-direction driving device 42D and the Y-direction driving device 42E are respectively formed by, for example, an air cylinder. The X-direction driving device 42D and the Y-direction driving device 42E may respectively be formed by a conveying mechanism comprising a hydraulic cylinder and a step motor.

As described above, a wet processing apparatus is so constituted that a plurality of wet processing chambers are provided in the direction of the conveyance of the transparent glass substrate SUB, the wet processing chamber being so constituted that the transparent glass substrate SUB can be inserted in a sheet method with the surface of it made stood erect. Furthermore, the unit-movement members 42A are disposed between wet processing chambers, the unit-movement member 42A conveying the transparent glass substrate SUB from the wet processing chamber to the successive wet processing chamber. The unit-movement member 42A each disposed between the wet processing chambers are connected by the connection members 42C. Common driving devices 42D and 42E for conveying the transparent glass substrate SUB are connected to a plurality of unit-movement members 42A. As a result of this, it is not necessary for the unit-movement members 42A between the wet processing chambers to be respectively provided with the driving device. Therefore, the number of the driving devices can be reduced, and the conveying device 42 can be simplified.

Furthermore, since the transparent glass substrates SUB (that is, the substrate supporting jig 40) can be successively conveyed from the above-described wet processing chamber to the next wet processing chamber, continuous wet processing can be realized.

As shown in Fig. 3, the conveying device 42 is, at the position thereof adjacent to the loader 1, provided with a stopper 42F. The stopper 42F is constituted in such a manner that in order to one by one convey the substrate supporting jig 40 from the loader 1, the movement of the unit-movement member 42Aa is restricted.

Next, the movement of the above-described wet processing device will be briefly described.

As shown in Figs. 3 and 4, the jig supporting frame 1B is mounted on the movable table 1C of the loader 1. A plurality of substrate supporting jigs 40 supporting, in a sheet method, the transparent glass substrate SUB is supported by the jig supporting frame 1B. The movable table 1C is moved in the direction of conveyance by the operation of the driving device 1D, thereby the substrate supporting jig 40 supported by the jig supporting frame 1B is moved in a stepped manner.

The substrate supporting jig 40 at the front end in the direction of conveyance which is being moved in a stepped manner is supported by the conveying finger portion 42B of the unit-movement member 42Aa due to the operation of the X-direction driving device 42D and the Y-direction driving device 42E, and is conveyed to the jig supporting portion 41B of the lifting device 41 of the pre-chamber 2.

Next, the surface of the transparent glass substrate SUB is washed in the liquid chamber portion in the sub-chamber 2 when the vertical movable frame 41A of the lifting device 41.

After the washing in the pre-chamber 2 has been completed, the substrate supporting jig 40 is conveyed to a position adjacent to the insertion portion of the pre-chamber 2 (the position at which the conveyance is started and completed) due to the upward movement of the vertical moveable frame 41A of te lifting device 41. Then, the transparent glass substrate SUB which has been washed in the pre-chamber 2 by the successive unit-movement member 42Ab is conveyed to the next developing chamber 3. When the substrate supporting jig 40 is conveyed from the pre-chamber 2 to the developing chamber 3, a new substrate supporting jig 40 is conveyed form the above-described loader 1 to the pre-chamber 2, the continuous processing being thus conducted.

The substrate supporting jig 40 which has been conveyed to the developing chamber 3 is inserted into the liquid chamber portion in which the developer is enclosed by the lifting device 41 in the similar manner so that the photoresist film on the surface of the transparent glass substrate SUB is subjected to the developing process. After a predetermined time period has been elapsed, new developer is sprayed to the surface of the transparent glass substrate SUB by the processing liquid spraying device 3D in synchronization with the action of raising of the transparent glass substrate SUB from the liquid chamber portion of the developing chamber 3. The developer may be sprayed by the processing liquid spraying device 3D when the transparent glass substrate SUB is insert into the developing chamber 3.

After the development conducted in the developing chamber 3 has been completed, the substrate supporting jig 40 is conveyed to the next developing chamber 4. As described above, the transparent glass substrate SUB is successively conveyed to the next wet processing chambers, and the substrate supporting jig 40 is accommodated, the developing (wet processing) is completed.

The tact of the above-described conveying device 42 (the tact of the unit-movement member 42A) is determined in accordance with the wet processing time in the developing portion. The wet processing time in each wet processing chamber is controlled by controlling the operation of the lifting device 41 in a sequence manner.

The sequential wet processing is completed after the etching process and stripping process have been successively conducted. Since different wet processing liquids are used in the pre-chamber 11 and the etching chamber 13 in the etching portion depending upon the layer to be subjected to etching, the wet processing chambers are arranged to be automatically changed in accordance with the process to be conducted.

After the serial wet processes in the developing portion of the wet processing apparatus, the substrate supporting jig 40 (that is, the transparent glass substrate SUB) accommodated in the unloader 10 can be transported to the dry etching device.

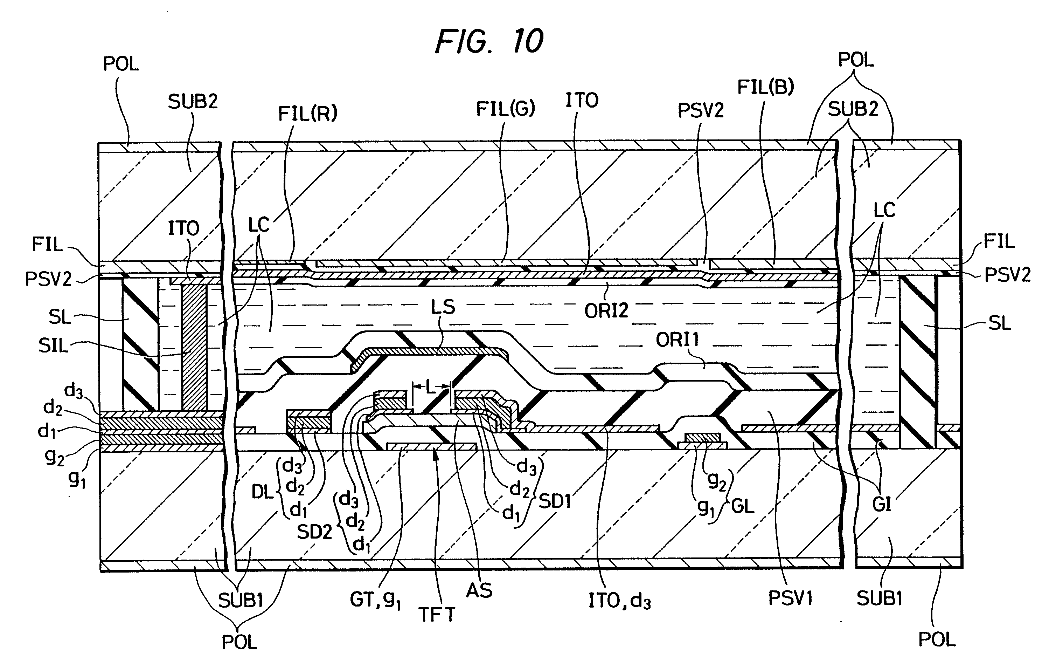

Next, the specific structure of an active matrix type of color liquid crystal display device which is actually subjected to the wet processing in the wet processing apparatus according to the present invention will be described briefly with reference to Fig. 10 (cross-section view of an essential portion).

As shown in Fig. 10, an active matrix type of liquid crystal device is so constituted that the inner surface (facing liquid crystal) of a lower transparent glass substrate SUB 1 thereof is provided with pixels each having the thin film transistor TFT and the transparent pixel electrode ITO. The transparent glass substrate SUB 1 is, for example, formed in the thickness of 1.1 [mm].

Each pixel is disposed in a region of intersection formed by the scanning signal line (gate signal line or horizontal signal line) GL and the image signal line (drain signal line or vertical signal line) DL. The scanning signal line GL is extended in the direction of the row and a plurality of the same are disposed in the direction of the column direction. The image signal line DL is extended in the column direction, and a plurality of the same are disposed in the direction of the row.

The thin film transistor TFT in each pixel mainly comprises a gate electrode GT, insulation film GI, i-type semiconductor layer AS, a pair of source electrode SD1 and drain electrode SD2.

The above-described gate electrode GT is formed by a first conductive film g1 of a single layer. The first conductive film g1 employs a chrome (Cr) film formed by, for example, spatters, and is formed in the film thickness of substantially 1000 [Å].

The above-described scanning signal line GL is formed by a combined film consisting of the first conductive film g1 and a second conductive film 2 disposed over the former. The first conductive film g1 forming the scanning signal line GL is formed in the same manufacturing process as that for the first conductive film g1 of he above-described gate electrode GT, and is formed integrally. The second conductive film g2 employs an aluminum (Al ) film formed by, for example, spatter, and is formed in the thickness of 2000 to 4000 [Å]. The second conductive film g2 is constituted in such a manner that the resistance of the scanning signal line GL can be reduced and the signal conductive speed (pixel selecting speed) can be increased.

The scanning signal line GL is constituted in such a manner that the width of the first conductive film g1 is smaller than that of the second conductive film g2. That is, the scanning signal line GL is constituted in such a manner that the stepped shape of the side walls thereof can be modified, and the surface of the insulation film GI disposed above the former can be flattened.

The insulation film GI is Used to serve as a gate insulating film of the thin film transistor TFT. The insulating film GI is formed above the gate electrode GT and the scanning signal line GL. The insulating film GI uses a silicone nitride film formed by, for example, plasma CVD, and is formed in the thickness of substantially 3000 [Å].

The i-type semiconductor layer AS serves as a region in which the channel of the thin film transistor TFT is formed. The i-type semiconductor layer AS is formed by an amolphous silicone film or a polycrystal silicone film, and is formed in the thickness of 200 to 3000 [Å].

The source electrode SD1 of the thin film transistor TFT and the drain electrode SD2 are each provided on the i-type semiconductor layer AS in such a manner that they are separated from each other.

Each of the source electrode SD1 and the drain electrode SD2 is formed in such a manner that a first conductive film d1, a second conductive film d2, a third conductive film d3 are successively laid starting from the lower layer positioned in contact with the i-type semiconductor layer AS. A first conductive film d1, a second conductive film d2 and a third conductive film d3 of the source electrode SD1 are formed in the same manufacturing process as that of the drain electrode SD2.

The first conductive film d1 employs a chrome film formed by spatters, and is formed in the thickness of 500 to 1000 [Å] (in this embodiment, it is substantially 600 [Å]). Since the chrome film increases its stress if the film thickness thereof is increased, it is needed to be formed in such a manner that the film thickness does not exceed 2000 [Å]. Chrome films have excellent contact with the i-type semiconductor layer AS. The chrome film forms a so-called barrier layer which can prevent aluminum to be described later in the second conductive film d2 from being diffused over the i-type semiconductor layer AS. As the first conductive film d1, metal (Mo, Ti, Ta, W) films with high fusing points or metal silicide ($MoSi_2$, $TiSi_2$, $TaSi_2$, $WSi_2$) films with high fusing points may be used as an alternative to the chrome film.

The second conductive film d2 employs an aluminum film formed by spatters, and is formed in the film thickness of 3000 to 4000 [Å] (in this embodiment, it is substantially 3000 [Å]). Since the aluminum film has relatively smaller stress than the chrome film so that it can be formed thick. As a result of this, it can reduce the resistance of the source electrode SD1, drain electrode SD2, and the image signal line DL. That is, the second conductive film d2 is so constituted that it can raise the operating speed of the thin film transistor TFT, and as well raise the speed of conducting the signals of the image signal line DL. As the second conductive film d2, an aluminum film to which silicone (Si), copper (Cu) or titan (Ti) is added may be employed as an alternative to the aluminum film.

The third conductive film d3 employs a transparent conductive film (ITO: Nesa film) formed by spatters, and is formed in the film thickness of 1000 to 2000 [Å] (in this embodiment, it is substantially 1200 [Å]). This third conductive film d3 forms the source electrode SD1, drain electrode SD2 and the image signal line DL, and also forms the transparent pixel electrode ITO.

The first conductive film d1 of the source electrode SD1 and the first conductive film d1 of the drain electrode SD2 are respectively formed in such a manner that the region in which the channel thereof is formed is larger than that in the second conductive film d2 and the third conductive film d3 which are respectively disposed above the former. The first conductive film d1 is constituted in such a manner that the size thereof is larger than the second conductive film d2 and the third conductive film d3 (each region on which the channel is formed of the first to third conductive films d1 to d3 may be on line). The first conductive film d1 of the source electrode SD1 and the first conductive film d1 of the drain electrode SD2 are constituted in such a manner that they define the length L of the gate of the thin film transistor TFT.

The source electrode SD1 is, as described above, connected to the transparent pixel electrode ITO. The source electrode SD1 is formed along the stepped-portion (the level difference corresponding to a thickness which is the total sum of the film thickness of the first conductive film g1 and that of the i-type semiconductor layer AS) of the i-type semiconductor.

Specifically, the source electrode SD1 comprises the first conductive film d1 formed along the stepped portion of the i-type semiconductor layer AS, the second conductive film d2 which is formed above the the first conductive film d1, and which is constituted in such a manner that the side to be connected to the transparent pixel electrode ITO is smaller than the first first conductive film d1, and the third conductive film d3 connected to the first conductive film d1 exposing over the second conductive film d2. The first conductive film d1 of the source electrode SD1 has an excellent adhesion capability to the i-type semiconductor layer AS, and is formed to serve as a barrier layer to protect the diffusion of substances mainly from the second conductive film d2. The second conductive film d2 of the source electrode SD1 is provided for the purpose of overcoming the stepped shape of the i-type semiconductor while the chrome film of the first conductive film d1 cannot overcome the same since it cannot be formed thick due to increase in its stress. That is, the second conductive film d2 improves its step coverage characteristic since it can be formed thick. Since the second conductive film d2 can be formed thick, it contributes the reduction in the resistance of the source electrode SD1 (also the drain electrode SD2 and the image signal line DL). Since the third conductive film d3 cannot overcome the stepped portion due to the i-type semiconductor layer AS of the second conductive film d2, it is constituted in such a manner that it can be connected to the first conductive film d1 by way of reducing the size of the second conductive film d2. Since the first conductive film d1 and the third conductive film d3 can be adhered well, and as well the size of the stepped shape at the connecting portion between them is small, they can be assuredly connected each other.

The drain electrode SD2 is integrally formed with the image signal line DL, they being formed in the same manufacturing process.

The above-described transparent pixel electrode ITO is provided for each pixel, and forms one of the pixel electrode of the liquid crystal display portion. The transparent pixel electrode ITO is connected to the source ELECTRODE sd1 of the thin film transistor TFT. A protection film PSV1 is formed over the thin film transistor TFT and the transparent pixel electrode ITO. The protection film PSV1 is mainly provided for the purpose of protecting the thin film transistor TFT from moisture or the like, and has a transparence and humidity resistance. The protection film PSV1 is formed by a silicon oxide film or a silicon nitride film formed by, for example, plasma CVD, and is formed in the film thickness of substantially 8000 [Å].

A shield film LS is provided over the protection film PSV1 on the thin film transistor TFT in order to prevent the external light from being made incident upon the i-type semiconductor layer AS used as the region in which the channel is formed. The shield film LS is formed by, for example, an aluminum film or a chrome film having excellent light insulation, and is formed in the thickness of 1000[Å] in a spatter manner.

A liquid crystal LC is enclosed in a space formed between the lower transparent glass substrate SUB1 and a upper transparent glass substrate SUB 2 in such a manner that it is restricted by a lower distributing film OR11 and a upper distributing film OR12 for setting the direction of the molecule of the liquid crystal.

The lower distributing film OR 11 is formed on the protection film PSV1 facing the lower transparent glass substrate SUB1.

The inner surface (facing the liquid crystal) of the upper transparent glass substrate SUB2 is provided with a color filter FIL, a protection film PSV2, a common transparent pixel electrode ITO and the above-described upper distributing film OR12, they being successively laid over each other.

The above-described common transparent pixel electrode ITO is constituted in such a manner that it faces the transparent pixel electrodes ITO provided to each pixel facing the lower transparent glass substrate SUB1, and is integrally formed with the neighboring common transparent pixel electrodes ITO.

The color filter FIL is formed by coloring body to be dyed formed by a resin material such as an acrylic resin with a dye stuff. The color filers FIL are disposed facing each pixel, and are color-divided.

The protection film PSV2 is provided for the purpose of preventing the dye stuffs which dyed the above-described color filter FIL into different colors from being leaked to the liquid crystal LC. The protection film PSV2 is formed by a transparent resin such as an acrylic resin and an epoxy resin.

This liquid crystal display device is constituted by individually forming the layers on the lower transparent glass substrate SUB1 and those on the upper transparent glass substrate SUB2, interposing the upper and the lower transparent glass substrates SUB1 and SUB 2, and enclosing the liquid crystal LC between them.

The central portion of Fig. 10 shows a cross section of a pixel, but the left portion shows a cross section of the left end portion of the transparent glass substrate SUB1 and SUB2 in which extension lines are present. The right portion shows the right end portion of the transparent glass substrate SUB1 and SUB2 in which any extension line is not present.

Sealing member SL shown respectively in the left portion and the right portion of Fig. 10 is so formed that it can seal the liquid crystal LC, and is formed along the whole peripheries of the transparent glass substrates SUB 1 and SUB2. The sealing member SL is formed, for example, an epoxy resin.

The above-described common transparent pixel electrode ITO facing the upper transparent glass substrate SUB2 is connected, at least one place thereof, is connected to the extension line layer formed in the lower transparent glass substrate SUB1 with a silver paste material SIL. This extension line layer is formed in the same manufacturing process as that of the above-described gate electrode GT. source electrode SD1 and the drain electrode SD2.

The above-described distributing films OR11 and OR12, transparent pixel electrode ITO, common transparent pixel electrode ITO, protection film PSV1 and PSV2 and the insulating film G1 are formed on the inside of the sealing material SL. A polarizing plate POL is formed on each outer surface of the lower transparent glass substrate SUB 1 and the upper transparent glass substrate SUB 2.

Table 1 at the end of the specification shows a schedule of wet processing which is applied to the above-described active matrix type of liquid crystal device.

As shown on TABLE 1, a first and second wet processes are the processes in which the pattern of the gate electrode GT of the thin film transistor TFT. The gate electrode GT is, as described above, formed in such a manner that the second conductive film g2 is laid over the first conductive film g1. The numbers shown in the processing schedule correspond to those of the above-described loader 1 and the wet processing chambers.

A third wet process is a process in which the pattern of the i-type semiconductor layer AS of the thin film transistor TFT is formed.

A fourth wet process is a process in which the pattern of the insulating film GI of the thin film transistor TFT.

Fifth and sixth wet processes are processes in which the pattern of the source electrode SD1 of the thin fil transistor TFT and the drain electrode SD2.

A seventh wet process is a process in which the pattern of the transparent electrode (or common transparent electrode ) ITO.

A eight wet process is a process in which the pattern of the protection film PSV is formed.

A ninth wet process is a process in which the pattern of the shield film LS is formed.

In a case where aluminum Aℓ layer including an additive such as titan Ti or silicon Si is used in the layers, a removal process by which the additive is removed is conducted.

As described above, in a wet processing apparatus, by constituting a substrate supporting jig (substrate supporting means)40 for supporting the transparent glass substrate SUB in a sheet manner and in such a manner that the surface of the transparent glass substrate SUB is actually stood erect and a wet processing means for applying wet processing to the above-described transparent glass substrate SUB held by the substrate supporting jig 40, uneven result of wet processing can be prevented, thereby a stable wet processing can be conducted. As a result of this, wet processing can be conducted in a mass manner. Furthermore, the area required to conduct wet processing can be reduced, and the size of the device can be reduced.


(EMBODIMENT II)

Embodiment II is a second embodiment of the present invention in which the above-described wet processing apparatus is further constituted in such a manner that a substrate supporting jig thereof is so formed that it can accurately support and convey and that an excellent stability can be obtained at the time of conveyance.

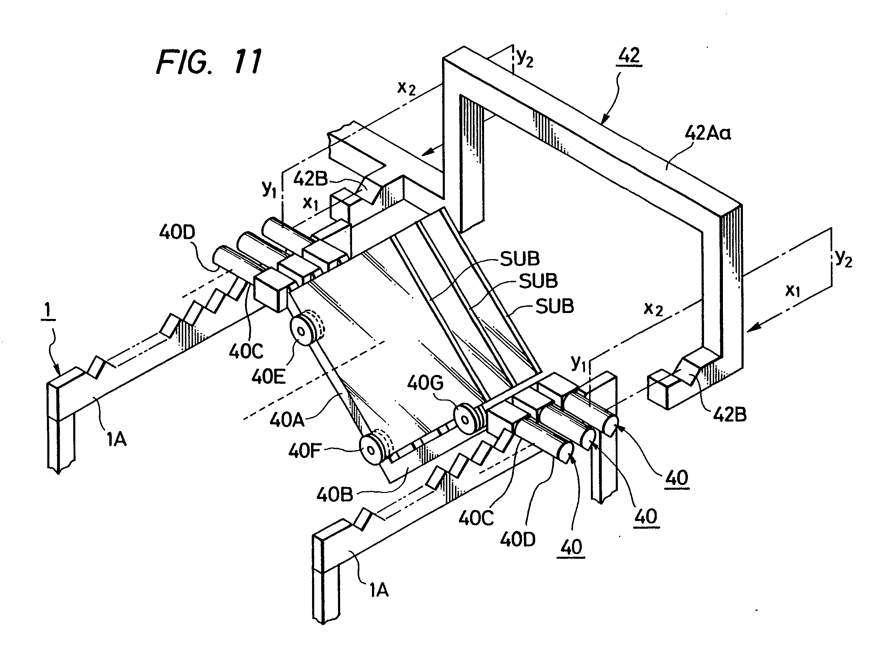

An essential portion of the wet processing apparatus is shown in Fig. 11 (partial perspective view), the wet processing apparatus being provided with a serial automated wet processing line system according to Embodiment II of the present invention.

As shown in Fig. 11, the wet processing apparatus according to this embodiment is constituted in such a manner that a portion 40C to be supported of the substrate supporting jig 40 and a portion 40D to be conveyed are respectively formed in a v-shape. A jig supporting portion 1A of the loader 1 which is to be brought into contact with the portion 40C to be supported of the substrate supporting jig 40 and a jig supporting portion 41B (omitted from the illustration) of the lifting device 41 of the wet processing chamber are also formed in a V-shape. The conveying finger portion 42B of the conveying device 42 which is to be brought into contact with the portion 40D to be conveyed of the substrate supporting jig 40 are also formed in a V-shape.

As described above, since the wet processing apparatus according to this embodiment is formed in such a manner that the portion 40C to be supported of the substrate supporting jig 40 is formed in a V-shape, and the jig supporting portion 1A of the loader 1 is formed in a V-shape in order to make this engage with the former, the substrate supporting jig 40 can be accurately supported by the loader 1, and the substrate supporting jig 40 can be stably held without occurrence of rotation of the same. The similar effect can be obtained in the lifting device 41. Furthermore, in the conveying device 42, the similar effect can be obtained.

The developing portion, etching portion and the stripping portion of the wet processing apparatus may be individually formed. That is, in this embodiment, a wet processing apparatus exclusively used for development, a wet processing apparatus exclusively used for etching, and a a wet processing apparatus exclusively used for stripping may be respectively provided.

Furthermore, the substrate supporting jig 40 used in the wet processing apparatus may be formed in such a manner that a plurality of the transparent glass substrates SUB can be supported, in a sheet manner, without occurrence of a fact that the surfaces (surface to be processed) of the transparent glass substrates SUB are not shielded by the other transparent glass substrates SUB at the time of wet processing. Specifically, the substrate supporting jig 40 may be formed in such a manner that it can support two transparent glass substrates SUB (sheet method) so as to make each reverse side of the two transparent glass substrates SUB faces each other. Furthermore, the substrate supporting jig 40 may be formed in such a manner that it can support the two transparent glass substrates SUB so as to make the two transparent glass substrates SUB respectively disposed on the same plane (sheet method).

Furthermore, in this embodiment, the wet processing apparatus may be formed in such a manner that the wet processing chamber, lifting device 41 and the unit-movement member 42A of the conveying device 42 are formed in a detachable unit, and a plurality of such units are disposed. The wet processing apparatus which is thus-formed in the unit method will cause ability of freely increasing or decreasing the number of wet processing chambers, as a result of this, the system can be improve in multiformity.

In the present invention, the etching chambers and the washing chambers of the above-described wet processing chamber for aluminum may be made of transparent glass. In this case, the conditions of etching of the transparent glass substrate SUB and the washing process can be observed.

(EMBODIMENT III)

Embodiment III is a third embodiment of the present invention in which the control of wet processing can be conducted with a certaintity, and the size of the wet processing apparatus can be further reduced.

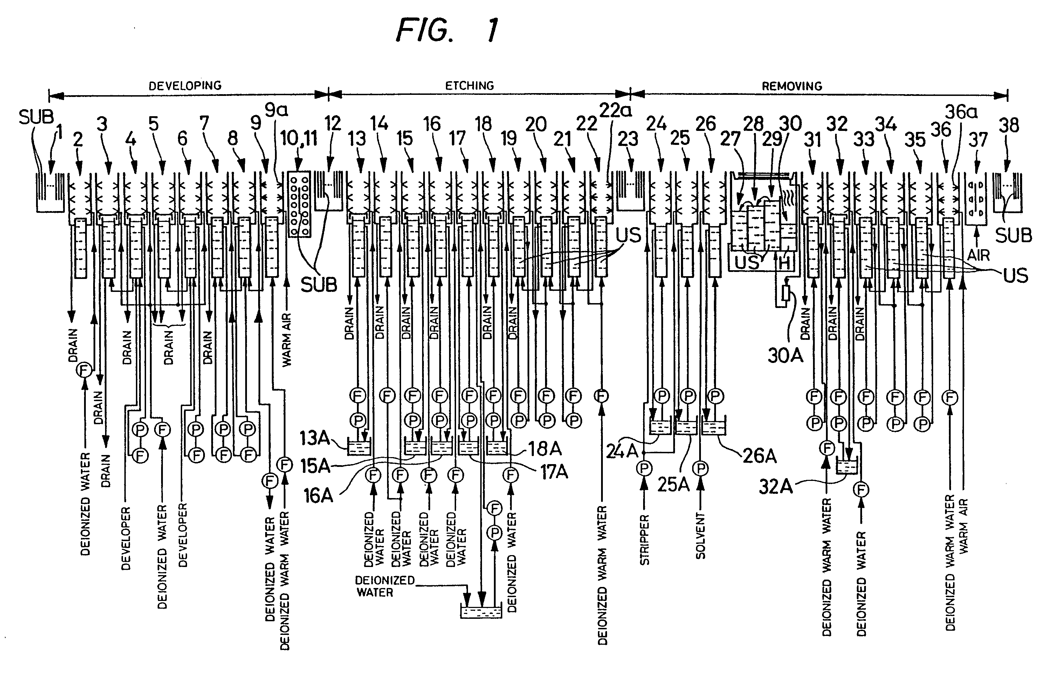

Fig. 1 (schematic structural view) shows a wet processing apparatus provided with a serial automated wet processing line system according to the Embodiment III of the present invention.

As shown in Fig. 1, the wet processing apparatus according to the Embodiment III is basically formed in the similar manner to that of the wet processing apparatus according to the above-described embodiment I described with reference to Fig. 2. That is, the wet processing apparatus according to this embodiment mainly comprises a serial automated wet processing line system provided with a developing portion, etching portion (wet etching portion) and a stripping portion.

The developing portion comprises wet processing chambers disposed between the loader 1 and the unloader 12 whereby, as shown on Table 2 at the end of the specification, wet processing are successively conducted starting from the left chamber viewed as in the figure. A plurality of wet processing chambers are disposed in the direction of conveyance of the transparent glass substrate SUB. The transparent glass substrate SUB is, similarly to that conducted in the above-described embodiments I and II, conducted in a sheet method by the conveying device 42 (however, a selection conveying device 43 to be described later is used for the developing chambers 3 to 6).

The transparent glass substrate SUB supplied by the above-described loader 1 is first conveyed to the pre-water washing chamber 2 in which the surface of the transparent glass substrate SUB is washed.

Next, it is conveyed to the first water washing chamber 3 and developing chamber 4 or the second water washing chamber 5 and developing chamber 6, in which the photoresist film applied to the surface of the transparent glass substrate SUB is developed and an etching mask is formed. The first water washing chamber 3 and the developing chamber 4 are filled with organic alkalic liquid or the like as the developer (wet processing apparatus). The second water washing chamber 5 and the developing chamber 6 are filled with inorganic alkalic liquid or the like as the developer. The first water washing chamber 3 and the developing chamber 4 and the second water washing chamber 5 and the developing chamber 6 are respectively and vertically connected in such a manner that the developing chamber and the water washing chamber (rinsing chamber) are connected. The developing chamber is disposed in the lower portion, while the water washing chamber is disposed in the upper, and a shutter portion to be described later is interposed therebetween. That is, the first washing chamber 3 and the developing chamber 4 and the

18

second water washing chamber 5 and the developing chamber 6 are formed in such a manner that the surface of the transparent glass substrate SUB can be developed in the developing chamber, and it can be immediately washed with deionized water.

Then, it is successively conveyed to the first water washing chamber 7and the second water washing chamber 8, respectively. As a result of this, the developer adhered to the surface of the transparent glass substrate SUB is further washed.

Next, it is conveyed to the warm water and drying chamber 9 in which it is heated and washed with deionized warm water at substantially 80[°C], and then hot air 9a is blown in the shape of an air knife so that the surface of the transparent glass substrate SUB is dried. As the hot air 9a, for example, nitrogen gas is used in order to prevent the surface of the transparent glass substrate SUB from being formed with water mark.

Then, it is conveyed to the baking furnaces 10 and 11 in which it is subjected to post baking. The post baking is conducted, for example, at substantially 120 [°C] for 4 minutes.

Next, it is accommodated in the unloader 12.

The etching portion is formed in such a manner that wet processing is successively and automatically conducted in the wet processing chambers disposed between the loader 12 and the unloader 23 starting from the left chamber as viewed in the figure. A plurality of wet processing chambers are disposed in the direction of conveyance of the transparent glass substrate SUB in the similar manner to that in the above-described developing portion. The conveyance of the transparent glass substrate SUB is also conducted similarly in a sheet manner and by the conveying device 42 (however, the selection conveying device 43 to be described later is used for the water washing and etching chambers 15 to 18).

The transparent glass substrate SUB supplied by the above-described loader 12 is first conveyed to the sub-chamber 13 in which the surface of the transparent glass substrate SUB is washed. The above-described loader 12 is formed in such a manner that the transparent glass substrate SUB which has been subjected to wet processing in the developing portion is supplied. This sub-chamber 13 is provided for the purpose of activating the surface of the material forming the pattern (in this embodiment, the material forming the pattern is chrome layer, aluminum layer, transparent electrode layer and silicon layer) causing the etching start in the etching chamber to be uniformed. The pre-chamber 13 is, as the wet processing liquid, filled with, for example, dilute hydrochloric acid. The pre-chamber 13 which serves as a water washing chamber is so formed that a shutter portion is disposed above the dilute hydrochloric acid chamber, in the similar manner to the water washing and developing chambers 3 to 6. That is, the pre-chamber 13 is formed in such a manner that after the surface of the transparent glass substrate SUB is treated with dilute hydrochloric acid, it can be immediately washed with deionized water. This pre-chamber 13 is provided with a pre-tank which is able to actually increase the quantity of dilute hydrochloric acid and thereby stably conduct the process.

Next, it is conveyed to the water washing chamber 14 in which the surface of the transparent glass substrate SUB is washed.

Then, it is conveyed to either of the water washing and etching chambers 15 to 18 in which the above-described layer on the surface of the transparent glass substrate SUB is formed to a predetermined pattern by using the etching mask formed by the above-described photoresist film. A plurality of water washing and etching chambers 15 to 18 are provided corresponding to the layers to be formed the pattern.

The water washing and etching chamber 15 is an etching chamber for the transparent electrode (ITO). The water washing and etching chamber 15 is formed by connecting, with a shutter portion, the water washing chamber and the etching chamber which is mainly filled with, as the etchant, for example, $HNO_3$ + $HCl$, the water washing chamber being disposed above the etching chamber.

The water washing and the etching chamber 16 is a etching chamber for aluminum ($Al$). This water washing and etching chamber 16 is formed by connecting, with a shutter portion, the water washing chamber and the etching chamber which is mainly filled with, as the etchant, for example, $H_3PO_4$ + $HNO_3$ + $CH_3COOH$, the water washing chamber being disposed above the etching chamber.

The water washing and etching chamber 17 is an etching chamber for chrome (Cr). This water washing and etching chamber 17 is formed by connecting, with a shutter portion, the water washing chamber and the etching chamber which is mainly filled with, as the etchant, for example, ceric nitrate ammon. the water washing chamber being disposed above the etching chamber.

The water washing and etching chamber 18 is an etching chamber for a silicon film ($n^+$ - Si). This water washing and etching chamber 18 is used for etching each first conductive film d1 of the source electrode SD1 and the drain electrode SD2 which form the thin film transistor TFT of the above-described active matrix type of liquid crystal display device in a case where the first conductive film d1 is formed by an $n^+$ type semiconductor layer. The $n^+$ type semiconductor layer is disposed between the i-type of semiconductor layer AS and the second conductive film (aluminum) d2, and is used so as to improve ohmic characteristics and to serve as a barrier layer. The $n^+$ type semiconductor layer is formed by a amolphous silicon film or multicrystal silicon film. This water washing and etching chamber 18 is formed by connecting, with a shutter portion, the water washing chamber and the etching chamber which is mainly filled with. as the etchant. for example, $HF + HNO_3 + CH_3COOH$, the water washing chamber being disposed above the etching chamber.

The water washing and etching chambers 15, 16, 17 and 18 are formed in such a manner that each layer on the surface of the transparent glass substrate SUB is subjected to etching in each etching chamber, and it can be immediately washed with deionized water. These washing and etching chambers 15, 16, 17 and 18 each provided with corresponding pre-tanks 15A, 16A, 17A, and 18A which actually increase the quantity of the etchant and thereby conduct stable process.

Next. it is successively conveyed to the first warm and deionized water chamber 19, second warm and deionized water chamber 20, and the third warm and deionized water chamber 21, in which the surface of the transparent glass substrate SUB to be further washed.

Then, it is conveyed to the warm and deionized water chamber 22 in which it is washed with warm and deionized water, and then it is subjected to hot air 22a for the purpose of drying the surface of the transparent glass substrate SUB. The hot air 22a uses nitrogen gas in order to water marks from being formed on the surface of the transparent glass substrate SUB.

Then, it is accommodated in the unloader 23.

The stripping portion is formed in such a manner that the wet processing is successively conducted in the wet processing chambers disposed between the loader 23 and the unloader 38 starting from the left chamber as viewed in the figure. A plurality of wet processing chambers are disposed, in the similar manner to that in the above-described developing portion and the etching portion, in the direction of the conveyance of the transparent glass substrate SUB. This conveyance is also conducted in the sheet method.

The transparent glass substrate SUB supplied by the above-described loader 23 is first and successively conveyed to the first stripping chamber 24 and the second stripping chamber 25, in which the above-described etching mask formed on the surface of the transparent glass substrate SUB is stripped (dissolved). In the first stripping chamber 24 and the second stripping chamber 25 is, in the similar manner to that in the above-described embodiment I. filled with, as a stripper, for example, a mixed solvent. The first stripping chamber 24 and the second stripping chamber 25 are respectively connected to a stripper spraying chamber (shower chamber) for spraying the stripper described in the above-described embodiment I above the stripping chamber which is filled with liquid. These first stripping chamber 24 and the second stripping chamber 25 are respectively provided with corresponding pre-tanks 24A and 25A which can actually increase the quantity of the stripper and thereby conduct the treatment stably.

Next. it is conveyed to the solvent rinse chamber 26. if necessary, in which the photoresist film left on the surface of the transparent glass substrate SUB and the stripper adhered to the surface of the same are respectively dissolved and removed. The solvent rinse chamber 26 is provided with the pre-tank 26A.

Then, it is successively conveyed to the first stripper removing chamber 27, second striper removing chamber 28, third striper removing chamber 29, and fourth stripper removing chamber 30, in which the striper adhered to the surface of the transparent glass substrate SUB is dissolved. The stripper removing chambers 27, 28, 29, and 30 are respectively filled with, as the stripper remover (wet processing liquid), for example, methylene chloride. The stripper remover in the fourth stripper remover chamber 30 is introduced through a water separator 30A into the third stripper remover chamber 29 after it has been heated by a heater H. is evaporated, and condensed. The stripper remover is introduced into the second stripper remover chamber 28 from the third stripper remover chamber 29, and it is introduced into the first stripper remover chamber 27 from the second stripper remover chamber 28. The stripper remover in the first stripper remover chamber 27 is introduced into the fourth stripper remover chamber 30, and is circulated. The stripper adhered to the surface of the transparent glass substrate SUB is successively dissolved starting from the first stripper remover chamber 27. and is finally vapor washed with steam from the stripper remover from the fourth stripper remover 30. In this vapor washing, as the surface of the transparent glass substrate SUB is relatively cooled down, the vapor can be easily adhered thereby the washing efficiency is improved.

Then, it is conveyed to the warm and deionized water chamber 31 in which the surface of the transparent glass substrate SUB is washed with warm and deionized water.

Next. it is conveyed to the water washing and activating chamber 32 in which the surface of a layer formed in a predetermined pattern on the surface of the transparent glass substrate SUB is activated. This activating process can cause the adhesive characteristics between the layer on which the pattern is formed and the other layer formed on the former layer. As the activater (wet processing liquid), for example, substantially 1%-fluoric acid is used. This water washing and activating chamber 32 is formed, similar to that of the above-described water washing and etching chamber, in such a manner that the water washing chamber is connected to the activator chamber with a shutter portion. the water washing chamber being disposed above the activator chamber. This water washing and activating chamber 32 is provided with a pre-tank 32A.

Then, it is conveyed to the first water washing chamber 33, second water washing chamber 34, and the third water washing chamber 35, in which the surface of the transparent glass substrate SUB is further washed.

Next, it is conveyed to the warm water and drying chamber 36 in which it is washed with deionized warm water and hot air 36a is blown so as to dry the surface of the transparent glass substrate SUB. The hot air 36a uses, similarly to the above-described hot air 9a and 22a, nitrigen gas.

Then, it is conveyed to a ultraviolet washing and drying chamber 37 in which the surface of the transparent glass substrate SUB is washed and dried. This ultraviolet washing and drying chamber 37 is provided for the purpose of supplying clean air to the chamber inside, applying ultraviolet to the clean air to generate ozone, and applying the ozone to the surface of the transparent glass substrate SUB. From the surface of the transparent glass substrate SUB, extremely small organic and oil can be specially removed so that it can be dried with excellent washing efficiency.

Then, it is accommodated in the unloader 38.

The wet processing according to this embodiment is completed after successively conducting the developing, etching and stripping.

Each wet processing chamber forming the serial automated wet processing line system is basically formed in the similar manner to those according to the above-described embodiment I. Next, the specific structure of the wet processing chamber in which the performance thereof is further improved will now be described.

The wet processing chambers, that is, the first washing and developing chambers 3 and 4, second washing and developing chambers 5 and 6 in the developing portion, the pre-chamber 13, water washing and etching chambers 15 to 18 in the etching portion, and the water washing and activating chamber 32 in the stripping portion (only the water washing and etching chamber 15 will be described as a representative) are formed as shown in Fig. 2 (partial and perspective cross-sectional view of the wet processing chamber). The water washing and etching chamber 15 is formed, which is basically formed similar to the wet processing chamber according to the embodiment I, in such a manner that the substrate supporting jig 40 and the vertical movable frame 41A and so on (omitted from the illustration) of the lifting device 41 are interposed and the surface of the transparent glass substrate SUB can be subjected to wet processing. The water washing and etching chamber 15 basically comprises a hollow parallelpiped having, in the upper portion thereof, an insertion portion into which the transparent glass substrate SUB is inserted. The water washing and etching chamber 15 is formed in such a manner that the transparent glass substrate SUB can be inserted in a sheet method with the surface of the transparent glass substrate SUB made actually stood erect.

A liquid chamber portion (etching chamber or a first wet processing portion) 15B for gathering the etchant (first wet processing liquid ) is disposed at the bottom of the water washing and etching chamber 15. The etchant in the liquid chamber 15B is first discharged to the pre-tank 15A, and is again supplied (in the direction designated by an arrow F) via the pump P and the filter F to be circulated.

A water washing chamber (washing chamber or second wet processing portion) 15C is disposed between the liquid chamber portion 15B of the etching chamber 15 and the insertion portion into which the transparent glass substrate SUB is inserted. This water washing chamber 15C is connected with a shutter portion 44A of a shutter device 44 on the liquid chamber portion 15B. A fluid spraying device 15D for spraying deionized water (washing liquid or second wet processing liquid) to the surface of the transparent glass substrate SUB is provided for the water washing chamber 15C. The deionized water sprayed through the fluid spraying device 15D is discharged (in the direction designated by an arrow G) from the water washing chamber 15C.

The above described shutter device 44 mainly comprises the shutter portion 44A, rotational shaft 44B, crank portion 44C, and open/close driving device 44D.

The shutter portion 44A is disposed between the liquid chamber portion 15B of the water washing and etching chamber 15 and the water washing chamber 15C. The shutter portion 44A is formed in such a manner that it opens and closes the insertion port in the liquid chamber portion 15B into which the transparent glass substrate SUB is inserted. The shutter portion 15B is substantially disposed in the water washing chamber 15C. This shutter portion 44A mainly opens so as to insert the transparent glass substrate SUB into the liquid chamber portion 15B, and closes when the transparent glass substrate SUB is drawn out after the surface of the same has been subjected to etching. The airtightness achieved between the shutter portion 44A and the insertion portion in the liquid chamber portion 15B is relatively sufficient, so that the shutter portion 44A can have the above-described transparent glass substrate SUB washed in the water washing chamber 15C after the same has been drawn out form the liquid chamber portion 15B. That is, the shutter portion 44A is formed in such a manner that if the surface of the transparent glass substrate SUB is washed in the water washing chamber 15C, the deionized water in it is prevented from being inevitably introduced in the liquid chamber portion 15B. The shutter portion 44A is made of, for example, peak resin or the other resin which can withstand each wet processing liquid and which is light, and has an excellent mechanical strength. The shutter portion 44A may be made by a metal such as stainless steel.

The rotational shaft 44B is provided for the purpose of opening and closing the above-described shutter portion 44A. It is drawn out from the water washing chamber 15C with an air sealing member (for example, "O" ring) 44.

A crank portion 44C is integrally formed with one end of the portion of the rotational shaft 44B which has been drawn out. This crank portion 44C is formed in such a manner that it makes the rotational shaft 44B rotate by the operation of the open/close driving device 44D in the direction designated by an arrow H.

The open/close driving device 44D is formed by, for example, an air cylinder, a hydraulic cylinder, or an electromagnetic solenoid. The open/close driving device 44D (operation of the shutter portion 4A) is sequence-controlled by a microcomputer (omitted from the illustration).

The wet processing apparatus constituted as described above is so formed in such a manner that the transparent glass substrates SUB (substrate supporting jig 40) conveyed by the above-described conveying device 42 is conveyed, by the selection conveying device 43, to any one of the water washing and etching chamber 15, or the successive water washing and etching chamber 16 to 18.

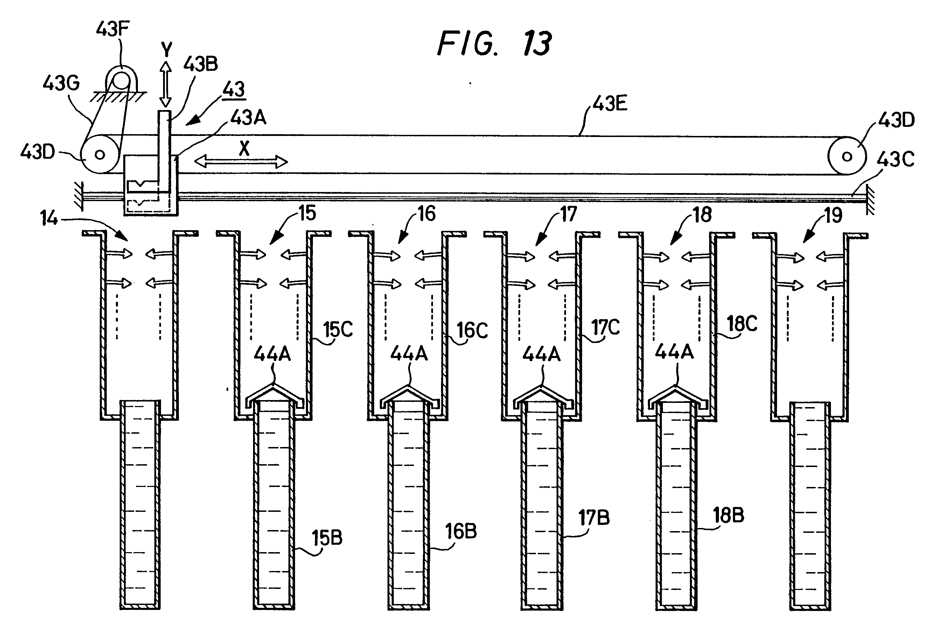

The selection conveying device 43 mainly comprises, as shown in Fig. 13 (a schematic structural view of a conveying device), a moving member 43A, jig conveying member 43B, guide shaft 43C, a pair of conveying rotational bodies 43D, conveying timing belt 43E, conveying driving device 43F, and a conveying timing belt 43G.

The moving member 43A is formed in such a manner that it movably supports the conveying member 43B in the direction designated by an arrow Y and is moved in the direction designated by an arrow X along the guide shaft 43C. This moving member 43A is formed in such a manner that it can be moved through the region between the water washing chamber 14 and the warm and deionized water chamber 19. It is formed in such a manner that it conveys the transparent glass substrate SUB from the water washing chamber 14 to any one of the water washing and etching chambers 15 to 18, and conveys the same which has been conveyed to the wart and deionized water chamber 19.

The jig conveying member 43B is formed in a manner substantially similar to the unit-movement member 42A shown in Fig. 11. That is, this jig conveying member 43B is formed in such a manner that it can convey the transparent glass substrate SUB in a sheet manner with the substrate supporting jig 40.

The conveying timing belt 43E wound to a pair of conveying rotational bodies 43D is connected to the moving member 43A, and thereby moves this moving member 43A.

The above-described conveying driving device 43F comprises, for example, a step motor controlled by a microcomputer (omitted from the illustration). The drive shaft of the above-described conveying driving device 43F is connected to one of the conveying rotational bodies 43D with the conveying timing belt 43G.

That is, the selection conveying device 43 is formed in such a manner that it moves the moving member 43A by the operation of the conveying driving device 43F with the conveying timing belt 43G and the conveying timing belt 43E, respectively. This selection conveying device 43 is formed in such a manner that it selects any one of the water washing and etching chambers 15 to 18 depending upon the material of the layer to be formed on the surface of the transparent glass substrate SUB, and conveys the transparent glass substrate SUB to the place selected.

For example, in a case where the transparent electrode (ITO) is formed on the surface of the transparent glass substrate SUB, the etching is conducted as follows:

First, the transparent glass substrate SUB which has been conveyed by the conveying device 42 with the substrate supporting jig 40 is washed in the water washing chamber 14.

Next, the transparent glass substrate SUB is selectively conveyed by the selection conveying device 43 from the water washing chamber 14 to the lifting device 41 (omitted from the illustration) of the water washing and etching chamber 15. When the transparent glass substrate SUB is conveyed to the water washing and etching chamber 15, the shutter portion 44A of the shutter device 44 is opened so that the transparent glass substrate SUB is moved to the liquid chamber 15B in which the surface of the transparent glass substrate SUB is subjected to etching. Then, the transparent glass substrate SUB is drawn out from the liquid chamber 15B, and is moved to the water washing chamber 15C, causing the shutter portion 44A to be closed. As a result of this, the surface of the transparent glass substrate SUB is immediately washed by the liquid spraying device 15D. The structure of the water washing and etching chamber 15 may be formed in such a manner that the transparent glass substrate SUB is washed in the water washing chamber 15C prior to subjecting it to etching in the liquid portion 15B. In this case, the water washing chamber 14 in the previous process can be deleted.

Then, after washing in the above-described water washing and etching chamber 15 has been completed, the transparent glass substrate SUB is conveyed to the warm and deionized water chamber 19 by the selection conveying device 43. The ensuing process are the same as those of the above-described description.

The above-described selection conveying device 43 is, although being omitted from the illustration, provided for the water washing and developing chambers 3 to 6 in the developing portion.

The water washing and etching chambers 16 to 18 respectively comprises, similar to the water washing and etching chamber 15, the liquid chamber portions (16B, 17B, and 18B) and water washing chambers (16C, 17C, and 18C).

As described above, the water washing and etching chamber (wet processing chamber) 15 of the wet processing apparatus is formed in such a manner that the liquid chamber portion (first wet processing portion) 15B in which etchant (first wet processing liquid) is used is, with the shutter portion 44A which can be opened and closed, connected to the water washing chamber (second wet processing portion) in which deionized water (second wet processing liquid) is used. As a result of this, since washing in the water washing chamber 15C can be immediately conducted after the etching process in the liquid chamber portion 15B has been completed, the completion time of etching can be controlled, and control of the time period needed to complete the etching process can be assuredly conducted.

Furthermore, since the provision of the shutter portion 44A between the liquid chamber portion 15B of the water washing and etching chamber 15 and the water washing chamber 15C prevents the etchant and the washing liquid to be mixed with each other, etching can be stably conducted.

Furthermore, since the water washing and etching chamber 15 is constituted in such a manner that the water washing chamber 15C is disposed above the liquid chamber portion 15B, the latter can be located in the area of the former. As a result of this, the areas of the two types of wet processing chambers can be reduced, causing the size of the wet processing apparatus to be decreased.

Furthermore, since the water washing and etching chambers 15 to 18 are respectively provided with the shutter portion 44A, each of the liquid chamber portions 15B to 18B is prevented from its wet processing liquid from being mixing with the other wet processing liquid due to drop of the wet processing liquid when the transparent glass substrate SUB conveyed by the selection conveying device 43 passes above the water washing and etching chambers 15 to 18.

Furthermore, since the wet processing apparatus according to this embodiment employs a sheet method, uneven results of processing can be reduced, as a result of which, stable wet processing can be conducted. Therefore, wet processing can be conducted in a quantity manner. Furthermore, since the area needed to conduct wet processing can be reduced by standing the transparent glass substrate SUB erect, the size of the wet processing apparatus can be reduced.

(EMBODIMENT IV)

Embodiment IV is a fourth embodiment of the present invention in which wet processing can be further stably conducted in the wet processing chamber of the wet processing device according to Embodiment III.

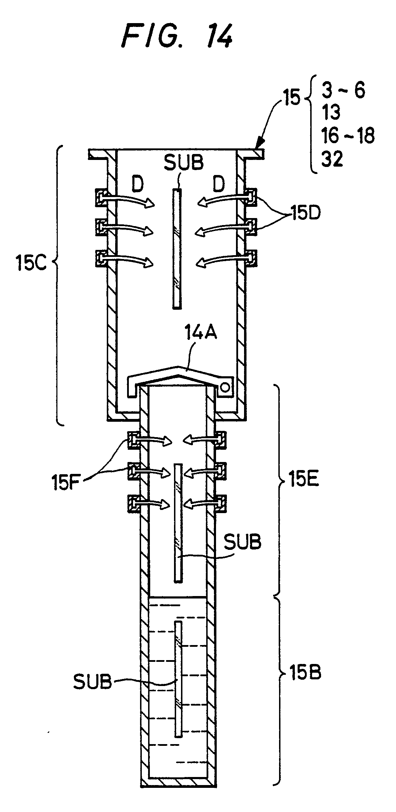

Fig. 14 (schematic cross-sectional view) shows the wet processing chamber of the wet processing apparatus provided with a serial automated wet processing line system according to Embodiment IV.

As shown in Fig. 14, the water washing and etching chamber 15 in the etching portion of the wet processing apparatus according to Embodiment IV is formed by three stages. That is, the water washing and etching chamber 15B comprises, as viewed from the bottom, a liquid chamber portion 15B in which etchant is gathered, an etching chamber (shower chamber) 15E for spraying etchant with the use of processing liquid spraying device 15F to the surface of the transparent glass substrate SUB, and a water washing chamber 15C for spraying the surface of the transparent glass substrate SUB with deionized water with the use of processing liquid spraying device 15D.

With the thus-constituted water washing and etching chamber 15, etching can be further stably conducted as described in the embodiment I and II. Furthermore, control of the etching time can be conducted more easily.

(Embodiment V)

Embodiment V is another, embodiment of the present invention in which the size of the above-described wet processing apparatus is intended to be reduced.

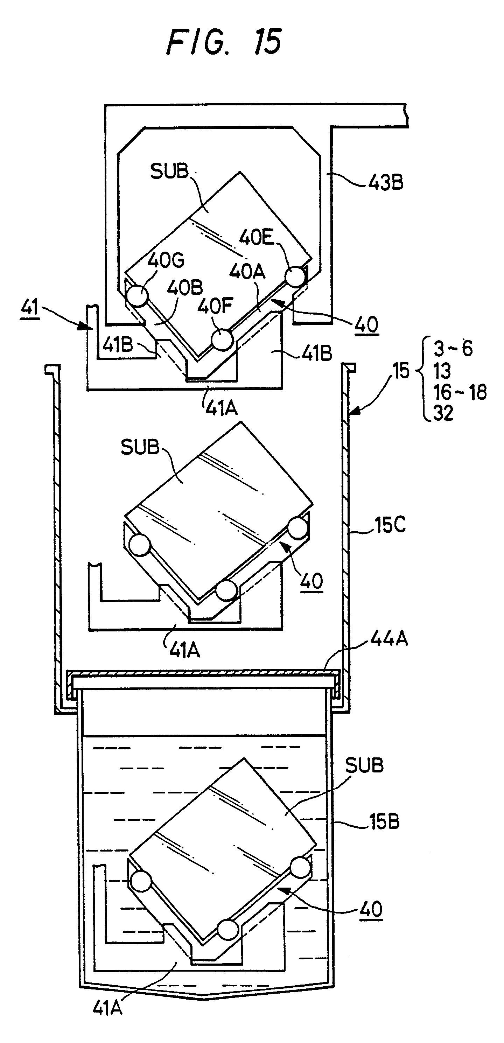

Fig. 15 (schematic cross-sectional view) of the wet processing apparatus comprising a serial automated wet processing line system according to Embodiment V of the present invention.

As shown in Fig. 15, the substrate supporting jig 40 of the wet processing apparatus according to the embodiment V comprises supporting sides 40A and 40B thereof each provided with the portion (40C) to be supported with which the jig supporting portion 41B of the lifting device 41 is brought into contact and or portion (40D) to be conveyed with which the jig conveying member 43B is brought into contact.

Since the portion to be supported and the portion to be conveyed can be disposed in the size of the supporting sides 40A and 40B of the substrate supporting jig 40, the size corresponding to them can be reduced. As a result of this, the size of the device can be reduced.

As a result of this, since all of the portions of the wet processing apparatus, that is, the wet processing chamber and loader 1 and so one can be decreased in size, therefore, the size of the wet processing apparatus can be reduced.

Although the present invention has been described in its preferred form with a certain degree of particularity, various changes and modifications may be made in the invention without departing from the spirit and scope thereof.

For example, the present invention is not limited to a glass substrate of an active matrix type of liquid crystal display device, it can be applied to a wet processing technology for a glass substrate of a time-division type of liquid crystal display device.

Furthermore, the present invention can be applied to wet processing technology for a semiconductor substrate forming a semiconductor wafer.

Furthermore, the present invention can be applied to a wet processing technology for a print circuit substrate.

Furthermore, the present invention can be applied to a transparent glass substrate such as reticle or photomask used in photolithography technology and wet processing technology for an optical lens.

Furthermore, the present invention may be formed in such a manner that different wet processing portions are connected with a shutter portion to form a wet processing chamber, and make the upper and lower wet processing portions serves as liquid chambers.

[Effect of the Invention]

The typical effects obtained by the present invention disclosed in this application will now be described.

In a wet processing technology, control of the wet processing can be assuredly conducted.

In a wet processing technology, size of the wet processing apparatus can be reduced.

In a wet processing technology, the wet processing can be conducted in a quantity manner and also the size of the wet processing apparatus can be reduced.

In a wet processing technology, the size of the substrate supporting jig can be reduced, and thereby the size of the wet processing apparatus can be reduced.

## TABLE 1

| Process No. | Process Name | Schedule | | |
|---|---|---|---|---|
| | | Developing Portion | Etching Portion | Stripping Portion |
| 1 | Gate Electrode Cr | 1 to 10 | 10 to 19 | 19 to 32 |
| 2 | Gate Electrode Aℓ | 1 to 10 | 10 to 19 (Residual) | 19 to 32 |
| 3 | i-semiconductor | 1 to 10 | Dry etching | 19 to 32 |
| 4 | Insulating layer | 1 to 10 | Dry etching | 19 to 32 |
| 5 | Source, Drain Electrode Aℓ | 1 to 10 | 10 to 19 (Residual) | 19 to 32 |
| 6 | Source, Drain Electrode Cr | 1 to 10 | 10 to 19 | 19 to 32 |
| 7 | Transparent Electrode ITO | 1 to 10 | 10 to 19 | 19 to 32 |
| 8 | Protection Film | 1 to 10 | Dry etching | 19 to 32 |
| 9 | Shielding FilmAℓ | 1 to 10 | 10 to 19 | 19to32 |

## TABLE 2

| | Schedule | Developing Portion | | | | |
|---|---|---|---|---|---|---|
| | Schedule No. | 1 | 2 | 3 | 4 | 5 |
| Process | Process Name | Loader | Pre Washing | Washing Dvloping | Washing Developing | Washing Developing |
| 1 | Gate Electrode Cr | O | O | P | P | O |
| 2 | Gate Electrode Aℓ | O | O | P | P | O |
| 3 | i-type Semiconductor | O | O | P | P | O |
| 4 | Insulating Film | O | O | P | P | O |
| 5 | SD Aℓ | O | O | P | P | O |
| 6 | SD Cr | O | O | O | O | P |
| 7 | Transparent Electrode ITO | O | O | P | P | O |
| 8 | Protection Film | O | O | P | P | O |
| 9 | Shielding Film Aℓ | O | O | P | P | O |

| | Schedule | Developing Portion | | | |
|---|---|---|---|---|---|
| | Schedule No. | 6 | 7 | 8 | 9 |
| Process | Process Name | Washing Developing | Washing | Washing | Warm Deionized Water Drying |
| 1 | Gate Electrode Cr | O | O | 0 | O |
| 2 | Gate Electrode Aℓ | O | O | O | O |
| 3 | i-type Semiconductor | O | O | O | O |
| 4 | Insulating Film | O | O | O | O |
| 5 | SD Aℓ | O | O | O | O |
| 6 | SD Cr | P | O | O | O |
| 7 | Transparent Electrode ITO | O | O | O | O |
| 8 | Protection Film | O | O | O | O |
| 9 | Shielding Film Aℓ | O | O | O | O |

27

| | Schedule | Developing Portion | | |
|---|---|---|---|---|
| | Schedule No. | 10 | 11 | 12 |
| Process | Process Name | Post | Bake | Unloader |
| 1 | Gate Electrode Cr | O | O | P |
| 2 | Gate Electrode Aℓ | O | O | P |
| 3 | i-type Semiconductor | O | O | P |
| 4 | Insulating Film | O | O | O |
| 5 | SD Aℓ | O | O | P |
| 6 | SD Cr | O | O | P |
| 7 | Transparent Electrode ITO | O | O | P |
| 8 | Protection Film | O | O | O |
| 9 | Shielding Film Aℓ | O | O | P |

| | Schedule | Etching Portion | | |
|---|---|---|---|---|
| | Schedule No. | 12 | 13 | 14 |
| Process | Process Name | Loader | Dilute Hydrochroric | Water Washing |
| 1 | Gate Electrode Cr | P | O | O |
| 2 | Gate Electrode Aℓ | P | O | O |
| 3 | i-type Semiconductor | P | O | O |
| 4 | Insulating Film | O | P | P |
| 5 | SD Aℓ | P | O | O |
| 6 | SD Cr | P | O | O |
| 7 | Transparent Electrode ITO | P | O | O |
| 8 | Protection Film | ·O | P | P |
| 9 | Shielding Film Aℓ | P | O | O |

| | Schedule | Etching Portion | | |
|---|---|---|---|---|
| | Schedule No. | 15 | 16 | 17 |
| Process | Process Name | Water Washing ITO ET | Water Washing Aℓ ET | Water Washing Cr ET |
| 1 | Gate Electrode Cr | P | P | O |
| 2 | Gate Electrode Aℓ | P | O | P |
| 3 | i-type Semiconductor | P | P | P |
| 4 | Insulating Film | P | P | P |
| 5 | SD Aℓ | P | O | P |
| 6 | SD Cr | P | P | O |
| 7 | Transparent Electrode ITO | O | P | P |
| 8 | Protection Film | P | P | P |
| 9 | Shielding Film Aℓ | P | P | P |

| | Schedule | Etching Portion | | |
|---|---|---|---|---|
| | Schedule No. | 18 | 19 | 20 |
| Process | Process Name | Water Washing n+ Si ET | Warm Deionized Water | Warm Deionized Water |
| 1 | Gate Electrode Cr | P | O | O |
| 2 | Gate Electrode Aℓ | P | O | O |
| 3 | i-type Semiconductor | O | O | O |
| 4 | Insulating Film | P | P | P |
| 5 | SD Aℓ | P | O | O |
| 6 | SD Cr | P | O | O |
| 7 | Transparent Electrode ITO | P | O | O |
| 8 | Protection Film | P | P | P |
| 9 | Shielding Film Aℓ | P | O | O |

| Process | Schedule | Etching Portion | | |
|---|---|---|---|---|
| | Schedule No. | 21 | 22 | 23 |
| | Process Name | Warm Deionized Water | Warm Deionized Water. Drying | Unloader |
| 1 | Gate Electrode Cr | O | O | P |
| 2 | Gate Electrode Aℓ | O | O | O |
| 3 | i-type Semiconductor | O | O | P |
| 4 | Insulating Film | P | P | P |
| 5 | SD Aℓ | O | O | O |
| 6 | SD Cr | O | O | P |
| 7 | Transparent Electrode ITO | O | O | P |
| 8 | Protection Film | P | P | P |
| 9 | Shielding Film Aℓ | O | O | P |

| | Schedule | Stripping Portion | | |
|---|---|---|---|---|
| | Schedule No. | ·23 | 24 | 25 |
| Process | Process Name | Loader | Resist Stripping | Resist Stripping |
| 1 | Gate Electrode Cr | P | O | O |
| 2 | Gate Electrode Aℓ | O | O | O |
| 3 | i-type Semiconductor | P | O | O |
| 4 | Insulating Film | P | O | |
| 5 | SD Aℓ | O | O | O |
| 6 | SD Cr | P | O | O |
| 7 | Transparent Electrode ITO | P | O | O |
| 8 | Protection Film | P | O | O |
| 9 | Shielding Film Aℓ | P | O | O |

| Process | Schedule | Stripping Portion | | | | |
|---|---|---|---|---|---|---|
| | Schedule No. | 26 | 27 | 28 | 29 | 30 |
| | Process Name | Solvent Rinse | Stripper Removal | Stripper Removal | Stripper Removal | Stripper Removal |
| 1 | Gate Electrode Cr | P | O | O | P | O |
| 2 | Gate Electrode Aℓ | P | O | O | O | O |
| 3 | i-type Semiconductor | P | O | O | O | O |
| 4 | Insulating Film | P | O | O | O | O |
| 5 | SD Aℓ | P | O | O | O | O |
| 6 | SD Cr | P | O | O | O | O |
| 7 | Transparent Electrode ITO | P | O | O | O | O |
| 8 | Protection Film | P | O | O | O | O |
| 9 | Shielding Film Aℓ | P | O | O | O | O |

| | Schedule | Stripping Portion | | | | |
|---|---|---|---|---|---|---|
| | Schedule No. | 31 | 32 | 33 | 34 | 35 |
| Process | Process Name | Warm Deionized Water | Water Washing Fluoric Acid | Water Washing | Water Washing | Water Washing |
| 1 | Gate Electrode Cr | O | O | O | O | O |
| 2 | Gate Electrode Aℓ | O | P | O | O | O |
| 3 | i-type Semiconductor | O | P | O | O | O |
| 4 | Insulating Film | O | P | O | O | O |
| 5 | SD Aℓ | O | P | O | O | O |
| 6 | SD Cr | O | P | O | O | O |
| 7 | Transparent Electrode ITO | O | P | O | O | O |
| 8 | Protection Film | O | P | O | O | O |
| 9 | Shielding Film Aℓ | O | P | O | O | O |

| | Schedule | Stripping Portion | | |
|---|---|---|---|---|
| | Schedule No. | 36 | 37 | 38 |
| Process | Process Name | Warm Deionized Water.Drying | UV/O$_3$ | Unloader |
| 1 | Gate Electrode Cr | O | P | O |
| 2 | Gate Electrode Aℓ | O | P | O |
| 3 | i-type Semiconductor | O | P | O |
| 4 | Insulating Film | O | P | O |
| 5 | SD Aℓ | O | P | O |
| 6 | SD Cr | O | P | O |
| 7 | Transparent Electrode ITO | O | P | O |
| 8 | Protection Film | O | P | O |
| 9 | Shielding Film Aℓ | O | P | O |

O represents the fact that the wet processing is needed.

P represents passing

## Claims

1. A wet processing apparatus comprising a wet processing chamber constituted in such a manner that a first wet processing portion in which a first wet processing liquid is used is connected to a second wet processing portion in which a second wet processing liquid which is different from said first wet processing liquid is used with a shutter device having a shutter portion which can be opened and closed in order to prevent said wet processing liquids from being mixed with each other.

2. A wet processing apparatus comprising wet processing chamber in which a substrate surface to be processed can be subjected to wet processing in such a manner that said substrate surface to be processed is inserted in a sheet method and that said substrate surface is substantially stood erect, and which are constituted in such a manner that a first wet processing portion in which a first wet processing liquid is used is connected to a second wet processing portion in which a second wet processing liquid which is different from said first wet processing liquid is used with a shutter device having a shutter portion which prevents said wet processing liquids from being mixed with each other.

3. A substrate supporting jig supporting a substrate to be processed whose surface to be processed is subjected to wet processing by a wet processing apparatus, said substrate supporting jig comprising a portion to be supported and a portion to be conveyed which are provided for supporting sides which support said substrate to be processed in a sheet manner and in such a manner that said surface to be processed is made stand substantially erect.

4. A wet processing apparatus for wet-processing a substrate surface to be processed comprising means for supporting said substrate to be processed in a sheet manner and making said substrate surface to be supported stand erect and means for wet-procesing said substrate to be processed which is supported by said means for supporting said substrate to be processed.

5. A wet processing apparatus in which substrate surface to be processed is subjected to wet processing, said wet processing apparatus comprising: a wet processing chamber into which said substrate surface to be processed can be inserted in a sheet method and said substrate surface to be processed can be made substantially stand erect; a liquid chamber portion for gathering a wet processing liquid which is disposed at the bottom of said wet processing chamber; and a processing liquid spraying device disposed between an insertion portion in said wet processing chamber into which said substrate surface to be processed is inserted and said liquid chamber portion, said processing liquid spraying device spraying said substrate surface to be processed with a wet processing liquid.

6. A wet processing apparatus for making a substrate surface to be processed subject to wet processing, said wet processing apparatus comprising: a plurality of wet processing chambers into which said substrate surface to be processed can be inserted in a sheet method with said substrate surface substantially stood erect, and which are disposed in the direction in which said substrate to be processed is conveyed; unit-movement members conveying said substrate to be processed from said wet processing chamber to the next wet processing chamber which are respectively disposed between wet processing chambers and which are connected with each other; and common driving device provided for the thus-connected unit-movement members between said wet processing chambers, said common driving device conveying said substrate to be processed.

7. A substrate supporting jig for use in a wet processing apparatus and supporting substrate to be processed of which surface to be processed is subjected to wet processing, said substrate supporting jig being characterized in that said substrate to be processed is supported in a sheet method with the substrate surface to be processed made substantially stand erect, and that a wet processing liquid adhered to said substrate surface to be processed is made drop from substantially one point.

8 . A substrate supporting jig for use in a wet processing apparatus for supporting a substrate whose surface is subjected to wet processing, said substrate supporting jig being characterized in that said substrate to be supported is supported in a sheet method with said surface to be processed made substantially stand erect, and that said substrate to be processed is supported in such a manner that said substrate surface to be processed is present in the direction in which gravitation is not effected.

9 . A substrate supporting jig for use in a wet processing apparatus which supports said substrate whose surface is subjected to wet processing, said substrate supporting jig being characterized in that said substrate to be processed is supported in a sheet method with said substrate surface to be processed made substantially erect, and that said substrate to be processed is supported by two supporting sides which intersects at a predetermined angle.

FIG. 1

EP 0 301 710 A1

# FIG. 2

FIG. 3

# FIG. 4

EP 0 301 710 A1

## FIG. 5

## FIG. 6

## FIG. 7

# FIG. 8

# FIG. 9

FIG. 10

FIG. 11

EP 0 301 710 A1

# FIG. 12

FIG. 13

# FIG. 14

# FIG. 15

| | DOCUMENTS CONSIDERED TO BE RELEVANT | | EP 88306024.6 |
|---|---|---|---|

| Category | Citation of document with indication, where appropriate, of relevant passages | Relevant to claim | CLASSIFICATION OF THE APPLICATION (Int. Cl.4) |
|---|---|---|---|
| X | EP - A1 - 0 061 300 (BASE ELECTRONICS LIMITED)<br>* Claims 1,6; Fig. 1,5 * | 1 | G 03 D 3/10<br>G 03 F 7/26 |
| A | EP - B1 - 0 080 659 (HOECHST)<br>* Claims * | 1,5 | |
| A | US - A - 3 727 533 (PERL)<br>* Abstract; fig. 6; column 5, lines 27-34 * | 1,2,4 | |
| A | DE - B2 - 2 119 598 (SIEMENS)<br>* Fig. 1,2; claim 6 * | 1,7 | |
| P,A | EP - A2 - 0 260 615 (HOECHST)<br>* Abstract * | 1,5 | TECHNICAL FIELDS SEARCHED (Int. Cl.4) |
| | ---- | | G 03 D<br>G 03 F<br>H 01 L<br>H 05 K<br>G 09 F |

The present search report has been drawn up for all claims

| Place of search | Date of completion of the search | Examiner |
|---|---|---|
| VIENNA | 07-11-1988 | SCHÄFER |